# NEW EUROPEAN PATENT SPECIFICATION

(11) **EP 1 202 608 B2**
(45) Date of publication and mention of the opposition decision: **08.02.2012**
(45) Mention of the grant of the patent: 15.06.2005
(21) Application number: 01125801.9
(22) Date of filing: 29.10.2001
(51) Int. Cl.: H05B 33/14, H01L 51/00, C09K 11/06

(54) **Organic light-emitting devices**
Organische lichtemittierende Bauelemente
Dispositifs organiques émetteurs de lumière

(30) Priority: 30.10.2000 JP 2000330356
(43) Date of publication of application: 02.05.2002
(73) Proprietor: KABUSHIKI KAISHA TOYOTA CHUO KENKYUSHO, Aichi-gun, Aichi-ken, 480-1192 (JP)
(72) Inventor: Ikai, Masamichi, K. K. Toyota Chuo Kenkyusho, Aichi-gun, Aichi-ken 480-1192 (JP); Takeuchi, Hisato, K. K. Toyota Chuo Kenkyusho, Aichi-gun, Aichi-ken 480-1192 (JP); Tokito, Shizuo, Kawasaki-shi, Kanagawa-ken 214-0031 (JP); Taga, Yasunori, K. K. Toyota Chuo Kenkyusho, Aichi-gun, Aichi-ken 480-1192 (JP)
(74) Representative: Kramer - Barske - Schmidtchen

(56) References cited:
- EP-A- 0 961 324
- Y.T.TAO ET AL.: "Dipyrazolopyridine derivatives as bright blue electroluminescent materials" APPLIED PHYSICS LETTERS, vol. 77, no. 7, 14 August 2000 (2000-08-14), pages 933-935, XP002254933
- ZHANG ZHILIN ET AL.: "Energy transfer and white emitting organic thin film electroluminescence" THIN SOLID FILMS, vol. 363, 2000, pages 61-63, XP002254934
- Z.Q. GAO ET AL.: "Blue organic electroluminescence of 1,3,5-triaryl-2-pyrazoline" SYNTHETIC METALS, vol. 105, 1999, pages 141-144, XP002254935
- X.H. ZHANG ET AL.: "Pyrazoline derivatives for blue color emitter in organic electroluminescent devices" THIN SOLID FILMS, vol. 371, 2000, pages 40-46, XP002254936
- X.H.ZHANG ET AL.: "Photoluminescence and electroluminescence of pyrazoline monomers and dimers" CHEMICAL PHYSICS LETTERS, vol. 320, 31 March 2000 (2000-03-31), pages 77-80, XP002254937
- X. H. ZHANG ET AL.: "The effect of functional group substitution on the photoluminescence and electroluminescence of pyrazoline derivatives" SYNTHETIC METALS, vol. 114, 2000, pages 115-117, XP002254938
- ZHILIN ZHANG ET AL.: "White-emitting organic diode with a doped blocking layer between hole-and electron-transporting layers" J.PHYS.D: APPL.PHYS., vol. 33, 2000, pages 473-476, XP002254939
- I. BENJAMIN ET AL.: "Newly synthesized conjugated copolymers for light emitting diodes" SYNTHETIC METALS, vol. 84, 1997, pages 401-402, XP002254940

## Description

The present invention generally relates to an organic light-emitting devices, and more particularly to an improvement in phosphorescent organic light-emitting devices.

### 2. Description of the Related Art

Organic light-emitting devices have received attention for use in the next generation of flat panel displays. The use of organic light-emitting devices enables the realization of a full-color display of high resolution having characteristics such as driving at low voltage direct current, wide viewing angle, self emission, and the like. To this end, it is necessary to further improve the efficiency of emission of organic light-emitting devices.

Conventional organic light-emitting devices emit light mainly through fluorescence. In such devices, electrons and holes are injected from electrodes, they travel toward their opposite electrodes, and they then re-combined in an emission layer in a certain ratio to produce excitons. When the excited state of the exciton returns to its ground state, light is generated. While there are two excited states, a singlet excited state wherein the spin directions of a pair of electrons are opposite and a triplet excited state in which groups of two electrons have the same electron spin direction, only the singlet excited state contributes to the above-described fluorescent emission. Because the production ratio of the singlet excited state to the triplet excited state may be one to three on the basis of inference by simple quantum mechanics, the maximum value of internal quantum efficiency for the organic light-emitting device using fluorescence is 25%. That is to say, 75% of excited state energy does not contribute to light emission. Further, the index of refraction (n) of an organic material used for the organic light-emitting device is approximately from 1.6 to 1.7 and the external emission efficiency (ηₑₓₜ) is = 1/(2n²) ≒ and 0.2, that is, a maximum of about 20% based upon the reflection and refraction law of classical optics. Accordingly, the external quantum efficiency for the organic light-emitting device using fluorescence is 25 % ×20% and estimated to be about 5% at the most.

It is therefore preferable to take advantage of light emission from the triplet excited state which accounts for 75% of excited state phosphorescence in order to increase the external quantum efficiency. If such utilization is made possible, the external quantum efficiency can be increased to up to 20%. To this end, an organic light-emitting device taking advantage of phosphorescence by the use of an iridium complex as an dopant has been proposed as described in, for example, M. A. Baldo, S . Lamansky, P. E. Burrows, M. E. Thompson, S . R . Forrest, Appl. Phys. Lett. 75(1999)4., "Very high-efficiency green organic light-emitting devices based on electrophosphorescence". According to the structure of such organic light-emitting device, a result has been obtained wherein the external quantum efficiency exceeds 5%.

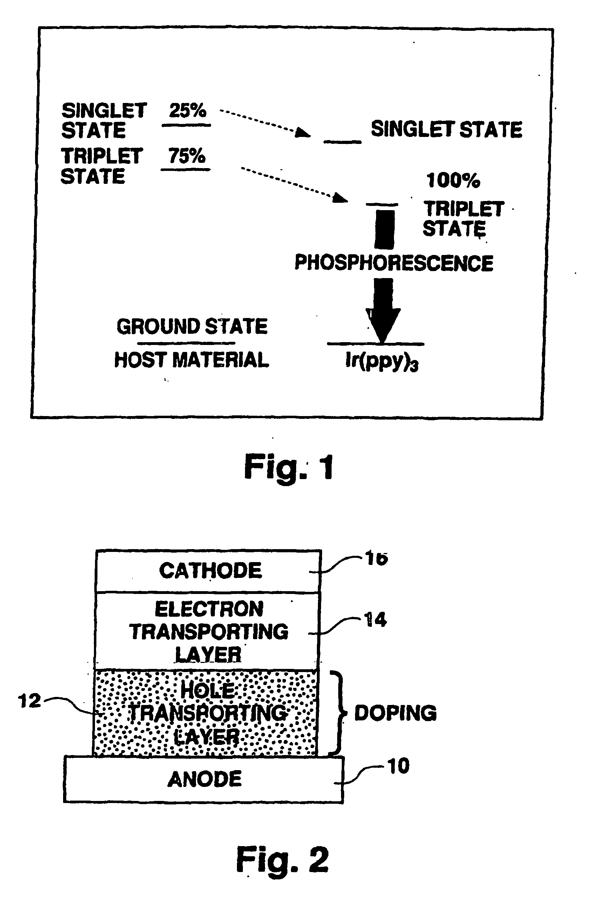

Fig. 1 is a diagram useful in explaining the principle of light emission of the above-described organic light-emitting device taking advantage of phosphorescence by the use of an iridium complex as a dopant. In Fig. 1, a host material doped with an iridium complex is first excited by re-combination of an electron with a hole. In this case, the singlet excited state is 25% and the triplet excited state is 75% as described above. Next, the excited state of the host material transfers to an iridium complex as a dopant, and the singlet excited state and the triplet excited state are generated, respectively. The singlet excited state of the iridium complex transfers further to the triplet excited state and, finally, the whole light emission is phosphorescence emission from the triplet excited state. Thereby, all energy of the excited state generated can be used as energy for light emission.

However, because the light emission efficiency of the above-described conventional organic light-emitting device taking advantage of phosphorescence does not yet reached 20%, which is the theoretical limit of light emission efficiency, it is necessary to further improve the light emission efficiency.

Further, as a host material doped with the above-described iridium complex, 4, 4' -N, N'-dicarbazole-biphenyl, **CBP** has, for example, been used. However, because this host material is poor in heat-resistance, there has been a problem that it can not be used in high temperature settings, such as within an automobile

Y.T. Tao et al., "Dipyrazolopyridine derivatives as bright blue electroluminescent materials", Applied Physics Letters, vol. 77, no. 7, 14 August 2000, pages 933-935, XP002254933 disclose an organic light-emitting device emitting fluorescence, wherein the device comprises PAP-X as a fluorescent compound doped in an electron transporting layer of TPBI (an imidazole compound) and wherein NPB and CBP are used as hole transporting layers.

The present invention has been made in view of the above-described conventional problem and an object of the present invention is to provide an organic light-emitting device having high light emission efficiency and high heat resistance.

The above object is achieved by an organic light-emitting device according to claim 1. Further developments of the present invention are set out in the dependent claims.

According to the present invention as claimed, because the glass transition temperature of the organic material is 100 °C and above, it is possible to increase the heat-resistance of the organic light-emitting device.

According to the present invention as claimed, it is possible to prevent an exciton generated in the light emitting layer from being absorbed in the anode, and, because an ionization potential of the electron transporting layer is large, a hole can be blocked to increase the light emission efficiency of the organic light-emitting device.

According to the present invention, the excited state can easily transfer from the host material to the guest material by the overlap of the spectra to increase the light emission efficiency of the organic light-emitting devices.

Furthermore, according to the present invention, it is possible to prevent the exciton from being absorbed into metal electrode from the light emitting layer and to prevent the hole injected into the light emitting layer from diffusing to the electron transporting layer.

### BRIEF DESCRIPTION OF THE DRAWINGS

Fig. 1 is a diagram for explaining the mechanism of phosphorescent emission when a phosphorescent molecule of iridium complex is used as a dopant. ,
Fig. 2 is a cross-sectional view of an embodiment 1 of an organic light-emitting device of the present invention.
Fig. 3 is the energy level diagramof the organic light-emitting device shown in Fig. 2.
Fig. 4 is a cross-sectional view of a modification of embodiment 1.
Fig. 5 is a energy level diatram of the organic light-emitting device shown in Fig. 4.
Fig. 6 is a cross-sectional view of a structure of an embodiment 2 of the organic light-emitting device of the present invention.
Fig. 7 is an energy level diagram of the organic light-emitting device shown in Fig. 6.
Fig. 8 is a cross-sectional view of a modification of embodiment 2.
Fig. 9 is an energy level diagram of the organic light-emitting device shown in Fig. 8.
Fig. 10 is a cross-sectional view of a working example of the organic light-emitting device corresponding to Fig. 4.
Fig. 11 is a cross-sectional view of a working example of the organic light-emitting device corresponding to Fig. 4.
Fig. 12 is a cross-sectional view of a comparison example corresponding to Figs. 10 and 11.
Fig. 13 is a diagram showing the ratio of the external quantum efficiency to the current density for the organic light-emitting devices shown in Figs. 10 and 12.
Fig. 14 is a diagram showing the ratio of the external quantum efficiency to the current density for the organic light-emitting devices shown in Figs. 11 and 12.
Fig. 15 is a diagram showing the ratio of the external quantum efficiency to the temperature of the device.
Fig. 16 is a diagram showing a working example of corresponding to embodiment 2 shown in Fig. 6.
Fig. 17 is a diagram showing a structure of a thin film for comparison of the heat-resistance of an organic thin film.
Fig. 18 is a diagram showing results of heat-resistance tests of the thin films shown in Figs. 17(a) and (b).
Fig. 19 is a diagram showing results of a heat-resistance test of the thin film shown in Fig. 17(c).
Fig. 20 is a diagram showing a relationship between the current density and the external quantum efficiency for the organic light-emitting devices of an example 7.
Fig. 21 is a diagram showing a relationship between the electric current density and the external quantum efficiency in an atmosphere of room temperature and 85 °C for the organic light-emitting devices of example 7.

### DESCRIPTION OF PREFERRED EMBODIMENTS

Referring now to the accompanied drawings, the embodiments of the present invention (hereinafter referred to as "embodiments") will be described below.

### Embodiment 1

Fig. 2 shows a cross-sectional view of the structure of the organic light-emitting device of the present invention. In Fig. 2, a hole transporting layer 12 is formed on an anode 10 formed of ITO or the like, an electron transporting layer 14 is formed on the hole transporting layer 12, and a cathode 16 is formed on the electron transporting layer 14. The hole transporting layer 12 and electron transporting layer 14 are formed by an organic compound and the organic light-emitting device comprises a plurality of organic layers.

In this embodiment, the hole transporting layer 12 is doped with a phosphorescent molecule and used as a light emitting layer. An organic material having the structural formula illustrated below is used as a host material in the organic layer constituting the hole transporting layer 12 used for the light emitting layer: 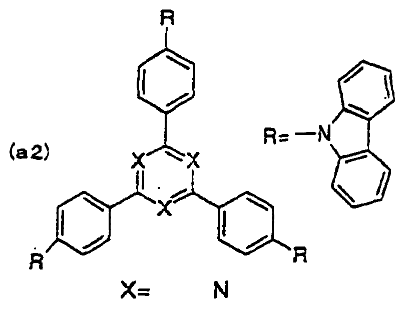 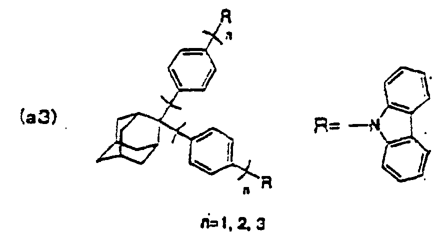 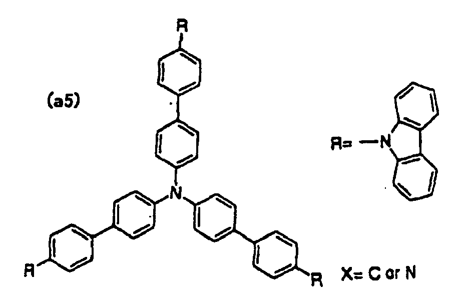 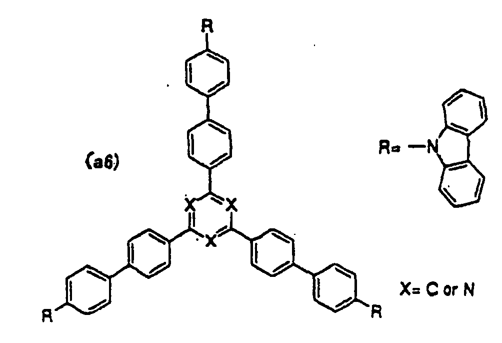 , wherein R is H, or hydrocarbons, or fluorocarbons.

(a3) is 2, 2-bis-(4-(4'-(N-carbazolyl) phenyl (or biphenyl or triphenyl)) adamantane. By the use of this compound as a host material, it is possible to increase the efficiency of emission and heat-resistance of the organic light-emitting device

The above-described host material has a glass transition temperature (Tg) of 100 °C and above and can be used in high temperature environments, such as applications within vehicles or the like. For materials such as the aforementioned CBP and the like, an organic thin film aggregates when heated over 60 °C and the surface of the thin film is roughened remarkably. On the other hand, because the glass transition temperature of the compound having the above-described basic skeleton (1) is 100 °C and above, it does not aggregate at temperatures of 100 °C and below if it is formed in a thin film, and smoothness of the thin film can be maintained. Therefore, the above-described host material can be used in high temperature environments, such as applications within vehicles or the like.

A phosphorescent molecule added as dopant to the above-described hole transporting layer 12 may include, for example, tris(2-phenylpyridine)iridium(III), Ir(ppy)₃)and the like, provided that the phosphorescent molecule is not necessarily restricted to the above-illustrated Ir(ppy)₃, as long as it emits phosphorescence. Ir(ppy)₃ is also commercially available and easily obtained.

As the electron transporting layer 14 can be used, for example, an organic compound having imidazole unit of two and above. As the cathode 16 can be used, for example, a metal electrode of Mg-Ag alloy, Al-Li alloy, LiF/Al, Al and so on. It is, further, preferable to use as an electron injection layer an organic layer doped with alkaline fluoride, alkaline oxide or metal. It is preferable to insert as a hole injection layer CuPc, starburst amines, vanadium oxides and so on between the anode 10 and the hole transporting layer 12.

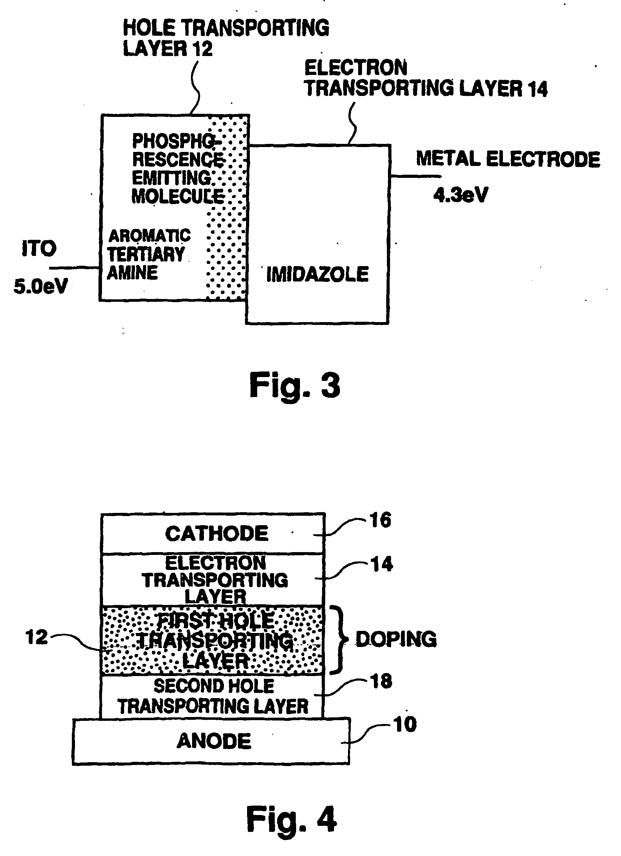

Fig. 3 shows an energy level diagram of the organic light-emitting device of this embodiment shown in Fig. 2. In Fig. 3, when a voltage is applied between the anode 10 (ITO electrode) and the cathode 16(metal electrode), electrons are injected from the electron transporting layer 14 constituted by the compound of imidazole family to the hole transporting layer 12 constituted by the compound of aromatic tertiary amine family to generate phosphorescence emission in the region doped with the phosphorescent molecule in the hole transporting layer 12 by the mechanism shown in Fig. 1.

As shown in Fig. 3, a section of the hole transporting layer 12 is doped with the phosphorescent molecule. That is, there is an area on the side of the anode 10 of the hole transporting layer 12 with a thickness of about 10 nm which is not doped with the phosphorescent molecule. The thickness of the above-described doped layer is preferably 50 nm or less, and more preferably 30 nm or less, from the interface of the hole transporting layer and the electron transporting layer 14. This is because an exciton in the triplet excited state has limitation in diffusion distance; the efficiency of light emission can not be further increased if the thickness of the doped layer exceeds 50 nm.

Fig. 4 shows a modification of the organic light-emitting device of this embodiment. In Fig. 4, a second hole transporting layer 18 is placed between a first hole transporting layer 12 as a light emitting layer and the anode 10. As the second hole transporting layer 18 can be used, for example, 4, 4'-bis[N-(1-naphthyl)-N-phenyl-amino]biphenyl, α-NPD). By adopting such a structure, adhesion of α-NPD to an ITO substrate can be greatly increased, and hole injection can be performed relatively easily because a work function of the ITO(5.0 eV) is close to the HOMO level of α-NPD (5.4 eV). Since, further, the hole mobility is large, the hole can be efficiently transported to the light emitting layer where it is re-combined with an electron efficiently to generate an exciton.

As explained above, materials such as TPTE and the like belonging to aromatic tertiary amines can be used for the hole transporting layer.

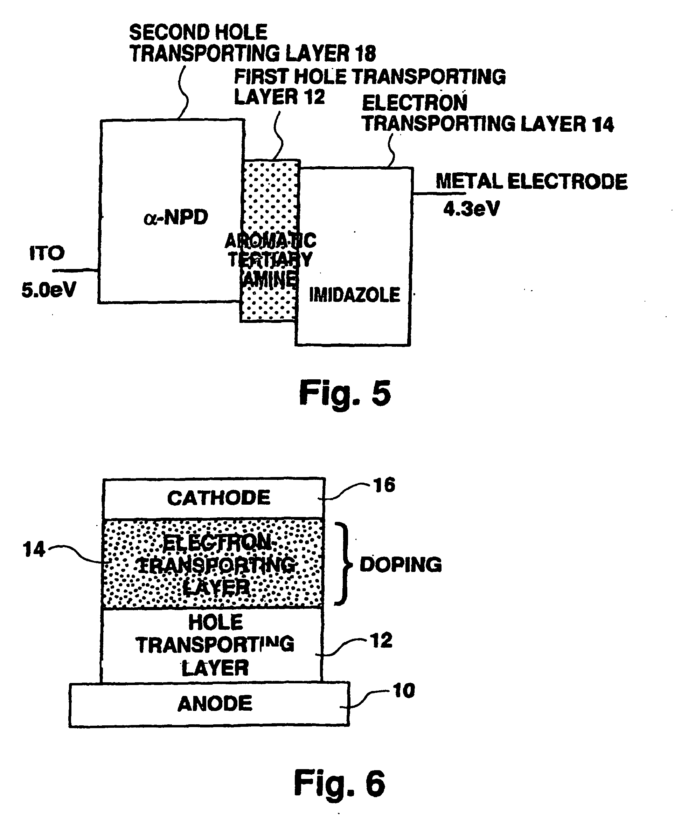

Fig. 5 shows an energy level diagram of a modification shown in Fig. 4. In Fig. 5, if a voltage is applied between the anode 10 (ITO electrode) and the cathode 16 (metal electrode), an electron is injected from the electron transporting layer 14 constituted by a compound of imidazole family to the first hole transporting layer 12 formed from a compound of aromatic tertiary amine family and a hole is injected from the second hole transporting layer 18 to the first hole transporting layer 12 to generate phosphorescent emission by virtue of the phosphorescent molecule in the first hole transporting layer 12 by the mechanism shown in Fig. 1 as mentioned above. In this modification, the entire hole transporting layer 12 as a light emitting layer may be doped with the phosphorescent molecule. Therefore, the thickness of the first hole transporting layer 12 may be as thick as that of the doped layer shown in Fig. 3.

In the organic light emitting device shown in Figs. 2 to 5 described above, the electron transporting layer 14 is formed between the hole transporting layer 12 as a light emitting layer and the cathode 16. If, however, the electron transporting layer is composed of a material the band-gap of which is larger than that of the hole transporting layer 12 (light emitting layer) and the ionization potential of which is larger than that of the light emitting layer by 0.1 eV, such as an organic compound of imidazole or fluorobenzene family (for example, C₆₀F₄₂) and the like, the emission efficiency can be further improved. This is possible because, as shown in Figs. 3 and 5, it is possible to prevent the triplet excited state in the hole transporting layer 12 doped with the phosphorescent molecule from being absorbed in the cathode 16 by enlarging the band-gap of the electron transporting layer 14, and the hole injected in the hole transporting layer 12 can be blocked so as not to flow into the hole transporting layer 14 by increasing the ionization potential of the electron transporting layer than that of the light emitting layer by 0.1 eV.

Further, a preferable host material constituting the hole transporting layer 12 may be one which itself phosphoresces. In such a case, if there is an overlap in peaks of the emission spectrum (phosphorescence spectrum) of the host material and the phosphorescence spectrum of the phosphorescent molecule which is a guest material added to the host material as a dopant, the energy of the excited state of the host material can be easily transferred to the guest material to increase further the emission efficiency. In particular, the overlap region of the above-described spectra is preferably 30% and above. For example, when the organic material having the above-described basic skeleton (1) is used as a host material, the energy gap obtained from its optical absorption edge is usually 3.0 eV and above. When Ir(ppy)₃ is used as the phosphorescent molecule, its phosphorescence spectrum has a main peak at 510 nm and a shoulder peak at 540 nm, that is, the spectrum ranges from 500 to 650 nm. Therefore, the phosphorescence spectrum of the organic material having the above-described basic skeleton (1) and that of Ir (ppy) overlap over a wide range. As such, the excited state can diffuse easily from the host material to the guest material to increase the emission efficiency.

Further, the overlap of the peak of the above-described spectrum may be an overlap of the phosphorescence spectrum (absorption spectrum) of the host material and that of the guest material. This is possible because the excited state can easily shift when the spectrums overlap. In such a case, it is also preferable that the overlap in the above-described spectrum be 30% or more.

### Embodiment 2

Fig. 6 shows a cross-sectional view of a structureof embodiment 2 of the organic light-emitting device of the prese*nt invention. In Fig. 6, structures of the anode 10 and the cathode 16 are the same as those of embodiment 1 shown in Fig. 2. In this embodiment, however, the electron transporting layer 14 is doped with the phosphorescent molecule and such electron transporting layer 14 is used as a light emitting layer. In such a case, the host material constituting the electron transporting layer 14 which is an organic layer doped with the phosphorescent molecule is an electron transporting compound of the triazole, imidazole, and oxadiazole families, wherein the above-described triazole family compound includes compounds having the structural formulae illustrated below. The glass transition temperature (Tg)of this host material is also 100 °C or more. 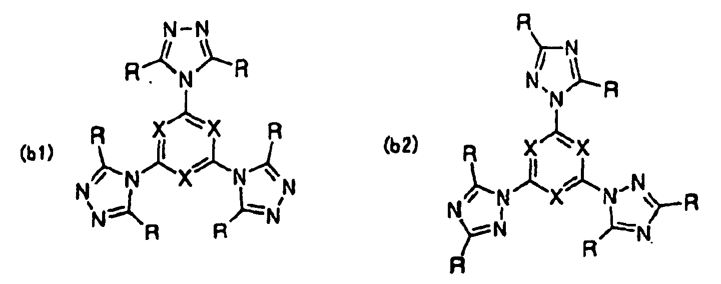 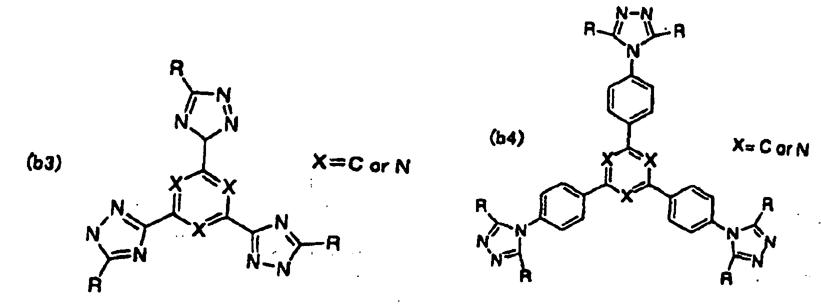 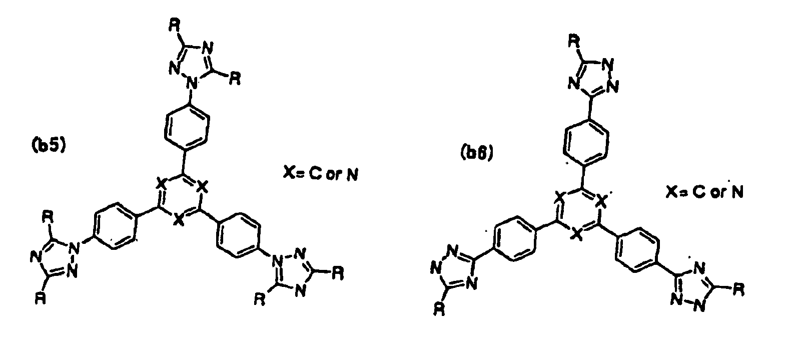 ,where 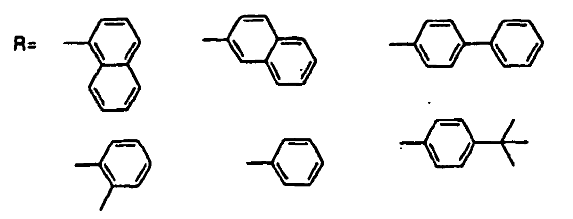 -H alkyl group having carbon atom of five less
, wherein R is H, or hydrocarbons, or fluorocarbons. 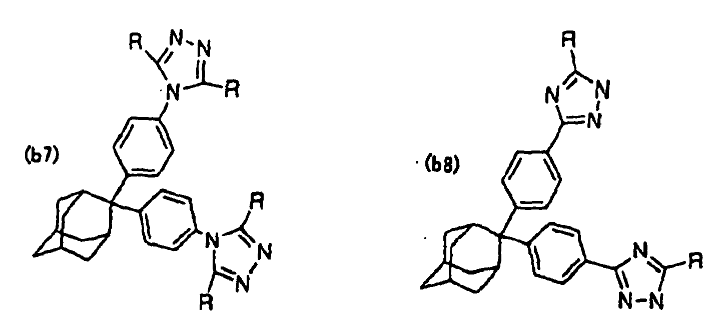 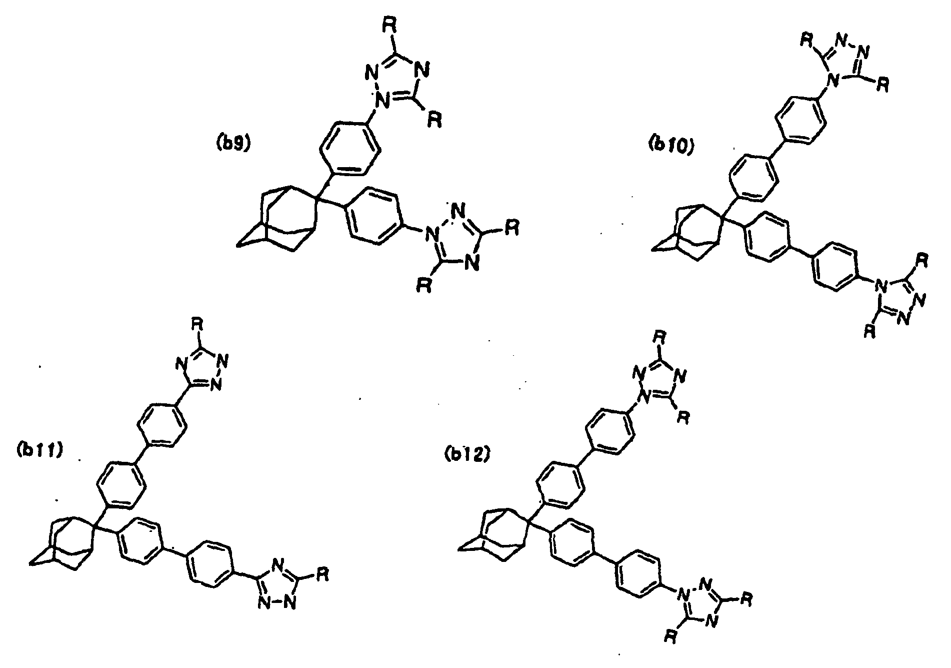 ,where 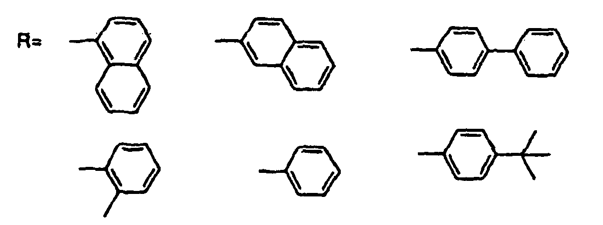 -H alkyl group having carbon atom of five less
, wherein R is H, or hydrocarbons, or fluorocarbons.

The above-described imidazole family compound includes compounds having the structural formulae illustrated below: 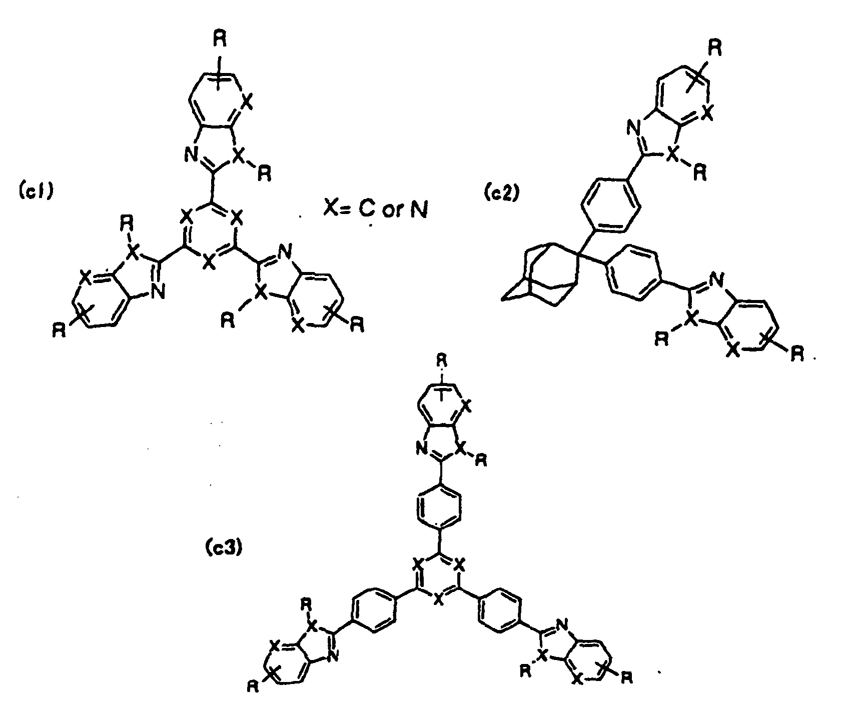 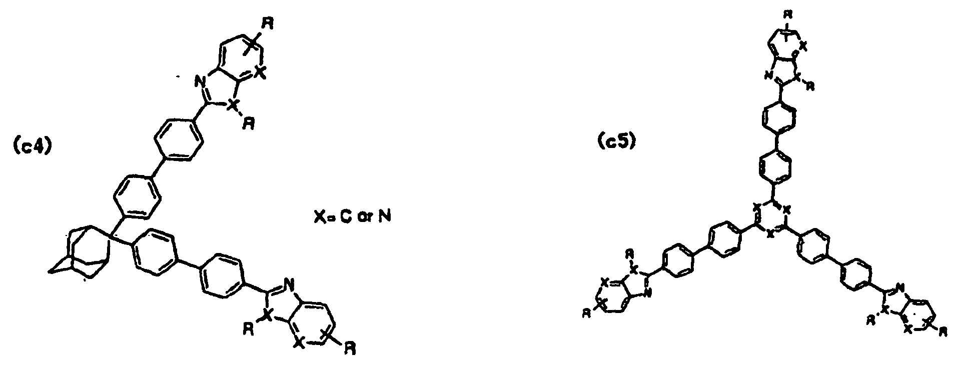 ,where 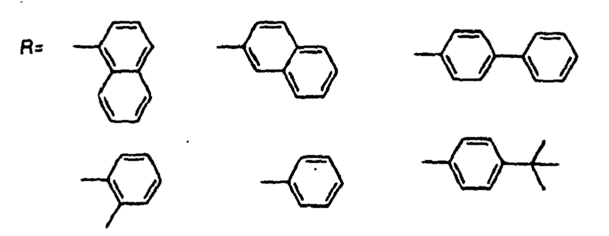 -H alkyl group having carbon atom of five less
, wherein R is H, or hydrocarbdns, or fluorocarbons.

Each contains an imidazole unit of two or more.

The above-described oxadiazole family compound includes compounds having the structural formulae illustrated below: 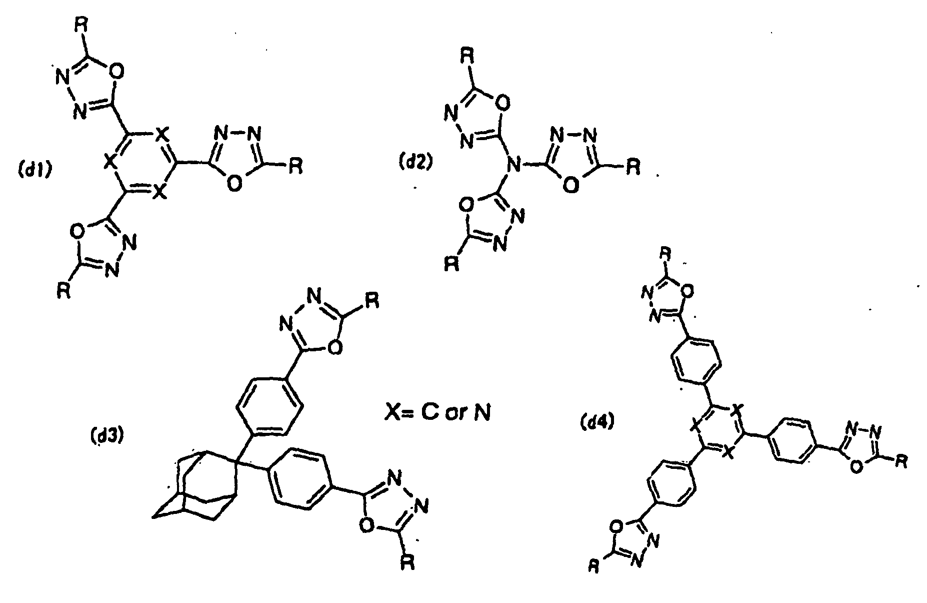 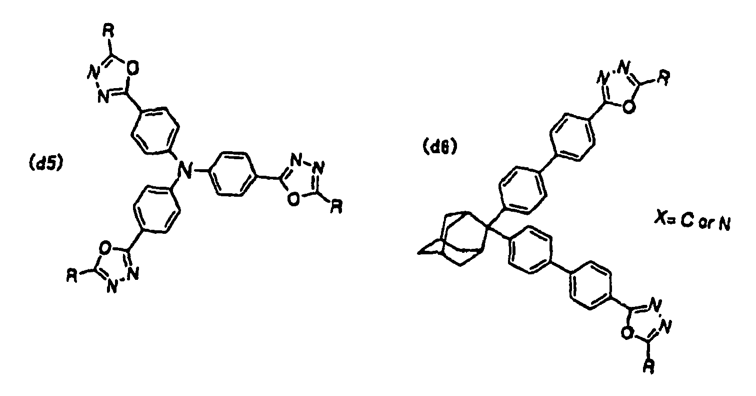 ,where 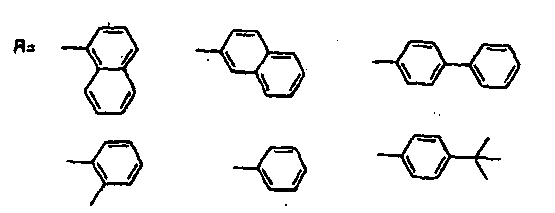 -H alkyl group having carbon atom of five less
, wherein R is H, or hydrocarbons, or fluorocarbons.

As the hole transporting layer 12 can be used an organic compound having at least two aromatic tertiary amine units, similarly to embodiment 1.

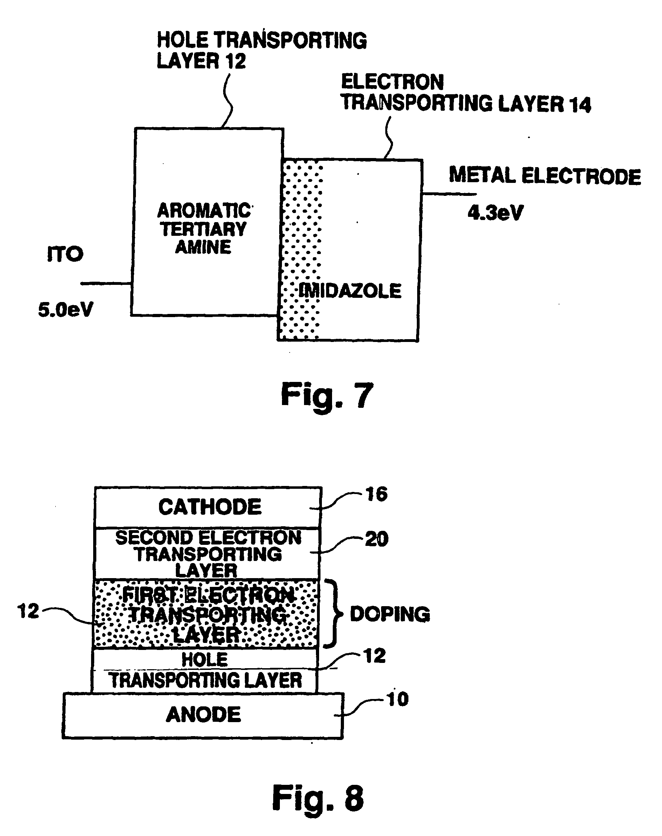

Fig. 7 shows a diagram of energy level of embodiment 2 shown in Fig. 6. When a voltage is applied between the anode 10 and the cathode 16, a hore is injected from the hole transporting layer 12 formed from an aromatic tertiary compound to the electron transporting layer 14 to generate phosphorescence emission in the region doped with the phosphorescent molecule as dopant. In this embodiment, a compound of imidazole family is used as a host material constituting the organic layer of the electron transporting layer 14.

Also in Fig. 7, similar to the case shown in Fig. 3, it is preferable that the thickness of the layer doped with the phosphorescent molecule be 50 nm or less, and more preferably 30 nm or less.

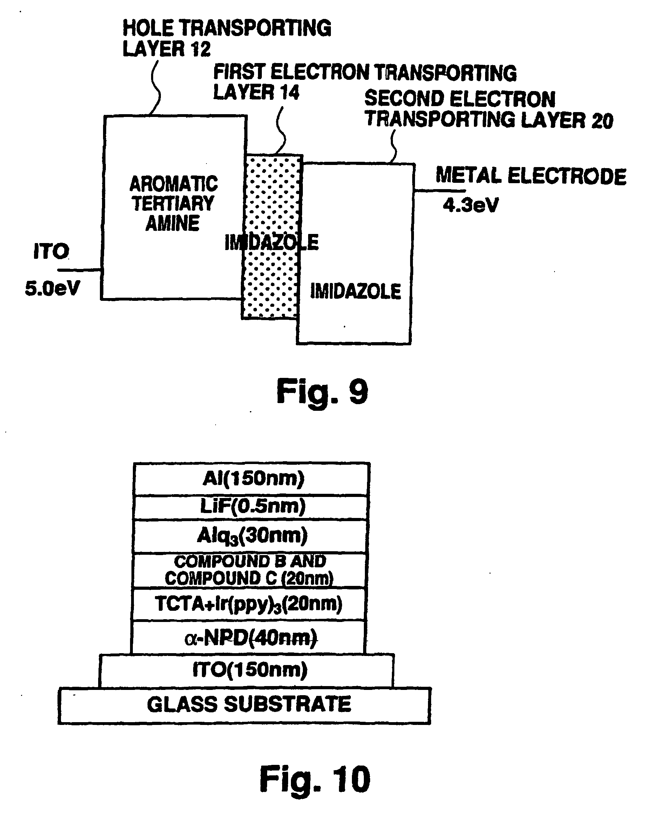

Fig. 8 shows a modification of the organic light-emitting device shown in Fig. 6. In the modification shown in Fig. 8, a second electron transporting layer 20 is formed between the first electron transporting layer 14 constituting the light emitting layer and the cathode 16. A diagram of energy level corresponding to this modification is shown in Fig. 9. As shown in Fig. 9, the ionization potential of the second electron transporting layer 20 is larger than that of the first electron transporting layer 14 as a light emitting layer by 0.1 eV and the movement of the hole injected into the first electron transporting layer 14 as a light emitting layer toward the second electron transporting layer 20 is blocked as described in embodiment 1.

Similar to embodiment 1, the band-gap of the second electron transporting layer 20 is larger than the first electron transporting layer 14 and it is possible to prevent the excited state generated in the first electron transporting layer 14 from being absorbed in the metal electrode as the cathode 16.

As the material for the above-described second electron transporting layer 20 can be used an organic compound of the imidazole or fluorobenzene family or the like.

Also, in this embodiment, the host material constituting the light emitting layer has the above-described basic skeleton (1) and there is an overlap region between the emission spectrum of the host material and the absorption spectrum of Ir(ppy)₃, which is a guest material. Therefore, the excited state generated in the host material can be easily transferred to the phosphorescent molecule to obtain high emission efficiency. Similar to embodiment 1, because there is an overlap region between the fluorescence spectrum of the host material and the absorption spectrum of the phosphorescent molecule of a guest material, the excited state generated in the host material can be easily transferred to the guest material to increase overall emission efficiency. In such a case, it is preferable that the overlap of the phosphorescence spectra or overlap of the fluorescence spectrum and the phosphorescence spectrum be 30% or more.

Illustrative examples of each of the embodiments described above are described in the next section.

### EXAMPLES (examples 1 to 4, 6 and 8 are not according to the present invention)

### Example 1

On a glass substrate was formed a 150 nm transparent electrode of ITO on which was deposited a 40nm α-NPD layer as a hole transporting layer by means of vacuum evaporation at the vacuum level of 3×10⁻⁷ Torr. The structure of the α-NPD is shown below:

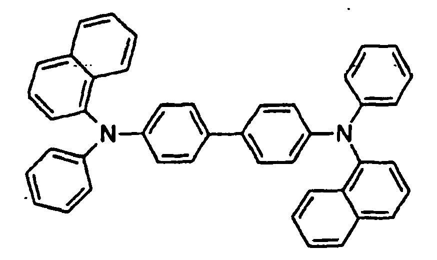

On the above-described α-NPD layer was formed a 20 nm TCTA layer as described above as a host material which was then doped with 5.5 wt% of Ir(ppy)₃ as a dopant. The structure of Ir(ppy)₃ is shown below:

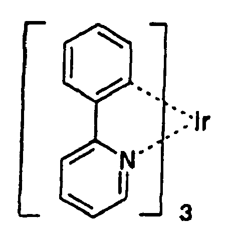

Further, an electron transporting organic compound of the fluorobenzene family, C₆₀F₄₂(hereinafter referred to as Compound C) having the structural formula shown below, was deposited in a 20 nm layer for blocking a hole so as not to move from a light emitting layer to the electron transporting layer 14 (hole blocking layer).

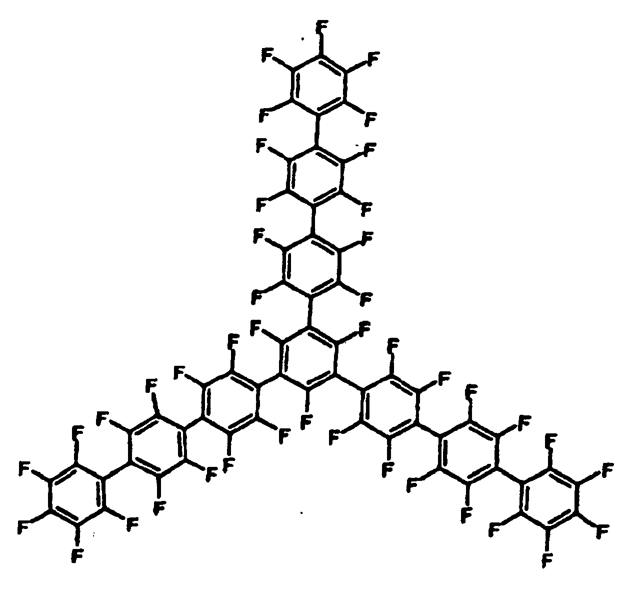

Further, Alq₃ having the structural formula shown below was deposited with thickness of 30 nm as the electron transporting layer on the hole blocking layer.

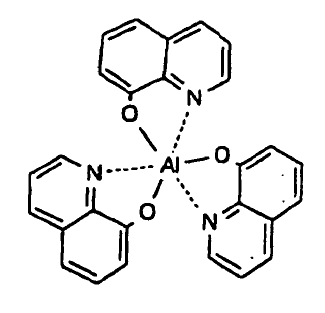

Finally, LiF and Al were deposited in thicknesses of 0.5 nm and 150 nm, respectively, to thereby form a metal electrode. This example 1 corresponds to a modification of embodiment 1 shown in Fig. 5.

A device formed as described above was placed in a chamber which was evacuated to a high vacuum. After purging thoroughly the inside of the chamber with nitrogen, an end of a seal glass was bonded by epoxy resin to the surface of the transparent electrode to seal. Thus, an organic light-emitting device was fabricated. A direct voltage was applied to the organic light-emitting device to drive continuously and the emission efficiency was measured. As a result, the maximum emission efficiency of 65.1 cd/A was obtained. In this case, the luminance was 716 cd/m² and the external quantum efficiency reached 18.0 % maximum after correction of angular distribution of emission at the driving voltage of 3.9 V.

Further, as the hole blocking layer was used C₆₀F₄₂(hereinafter referred to as Compound B) having the structural formula shown below which was an organic compound of an electron transporting fluorobenzene family instead of the above-described Compound C.
A device on which was deposited 20 nm of the Compound B was formed.

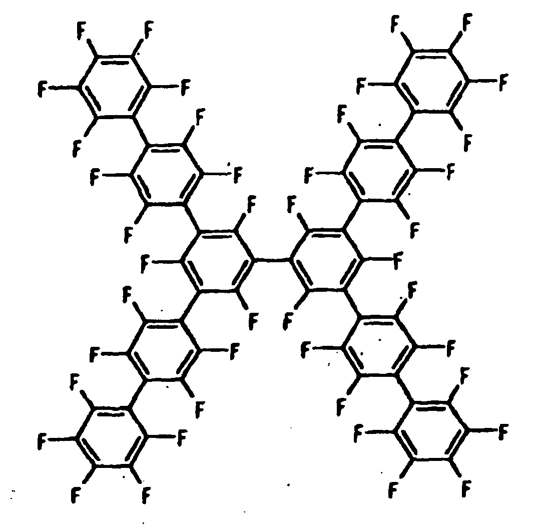

A direct voltage was applied to the organic light-emitting device using the Compound B to drive continuously and the emission efficiency was measured. As a result, a maximum emission efficiency of 73.0 cd/A was obtained. In this case, the luminance was 401.3 cd/m² and the external quantum efficiency reached a maximum of 19.2% after correction of angular distribution of emission at the driving voltage of 3.52 V.

A method for producing the above mentioned compounds B and C is disclosed in Y. Sakamoto, T. Suzuki, A. Miura, H. Fujikawa, S. Tokito, and Y. Taga, J. Am. Chem. Soc. 122, (2000) 1832.

Across-sectional view of the structure of the above-described device of example 1 was shown in Fig. 10. Note that, whereas a glass substrate is used in Fig. 10, substrate material is not limited to glass, and plastics, ceramics, or the like may also be applicable.

### Example 2

On a glass substrate was formed a transparent electrode of ITO in 150 nm on which was deposited a α-NPD layer of 40 nm by means of vacuum evaporation at the vacuum level of 3×10⁻⁷ Torr. A layer of TCTA as a host material doped with 5.5 wt % of Ir(ppy)₃ as a dopant was formed in 20 nm on this α-NPD layer similarly to example 1. Further, 50 nm of 2, 2', 2"-(1, 3, 5-phenylene)tris[1-phenyl-1H-benzimidazole], TPBI) having the structural formula shown below was deposited as a hole blocking layer for blocking a hole from moving out from the light emitting layer. A method for producing TPBI is disclosed in U. S. Patent 5,645,948 (Shi et al. Jul. 8, 1997).

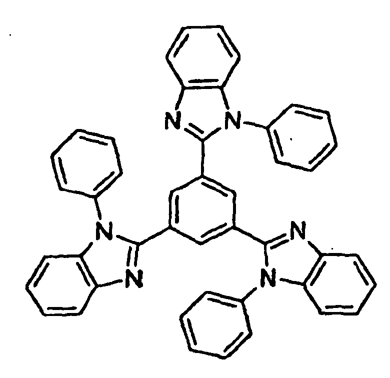

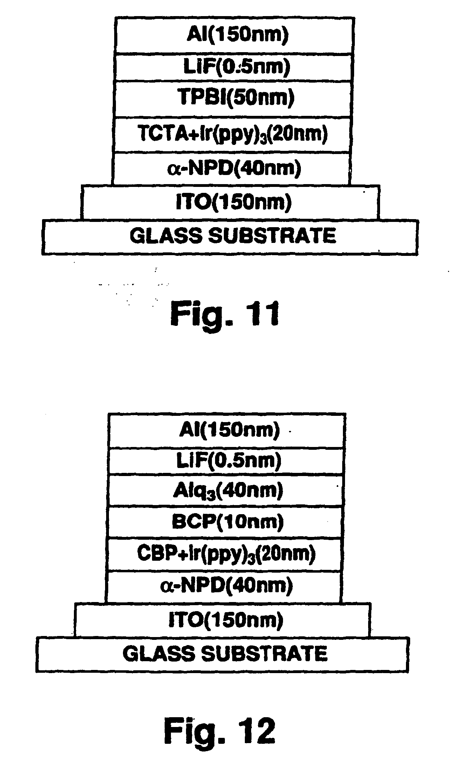

Further, LiF and Al were deposited thereon in thicknesses of 0.5 nm and in 150 nm, respectively, to form a metal electrode. A cross-sectional view of the device of this example is shown in Fig. 11. Note that, whereas a glass substrate is used in Fig. 11, substrate material is not limited to glass, and plastics, ceramics, or the like may also be applicable.

Similarly to example 1, the device shown in Fig. 11 corresponds to a modification of embodiment 1 shown in Fig. 5.

The device formed in the manner described above was placed in a chamber which was evacuated to a high vacuum. After thoroughly purging the inside of the chamber with nitrogen, an end of a seal glass was bonded by epoxy resin to the surface of the transparent electrode to seal. Thus, an organic light-emitting device was formed. A direct voltage was applied to the organic light-emitting device to drive continuously and the emission efficiency, luminance, external quantum efficiency and so on were measured. As a result, a maximum emission efficiency of 61 cd/A was obtained. The luminance was 1350 cd/m² and the external quantum efficiency reached 16.0 % maximum after correction of angular distribution of emission at the driving voltage of 4.9 V. Comparison Example 1

On a glass substrate was formed a transparent electrode of ITO having a thickness of 150 nm on which was deposited by means of vacuum evaporation at the vacuum level of 3×10⁻⁷ Torr, a 40 nm α-NPD layer as a hole transporting layer. Thereon was deposited a light emitting layer of 20 nm using CBP as a host material doped with Ir(ppy)₃ as dopant. The concentration of the dopant in this case was 7.5%. Then, on the light emitting layer was formed 10 nm layer of bathocuproine (BCP, commercially available) having the structural formula shown below as a hole blocking layer for blocking a hole injected into the light emitting layer from diffusing out.

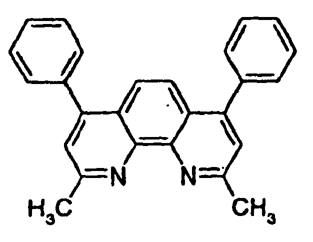

On the BCP layer was deposited 40 nm of Alq₃ as an electron transporting layer. Next, LiF and Al were deposited in thicknesses of 0.5 nm and in 150 nm, respectively, to form a metal electrode. A cross-sectional view of the organic light emitting device formed as described above is shown in Fig. 12.

A direct voltage was applied to continuously drive the organic light-emitting device of comparison example 1, and the emission efficiency was measured. As a result, a maximum emission efficiency of 30.1 cd/A was obtained in the region of low current density. After correction of angular distribution, the maximum external quantum efficiency was 8.3% .

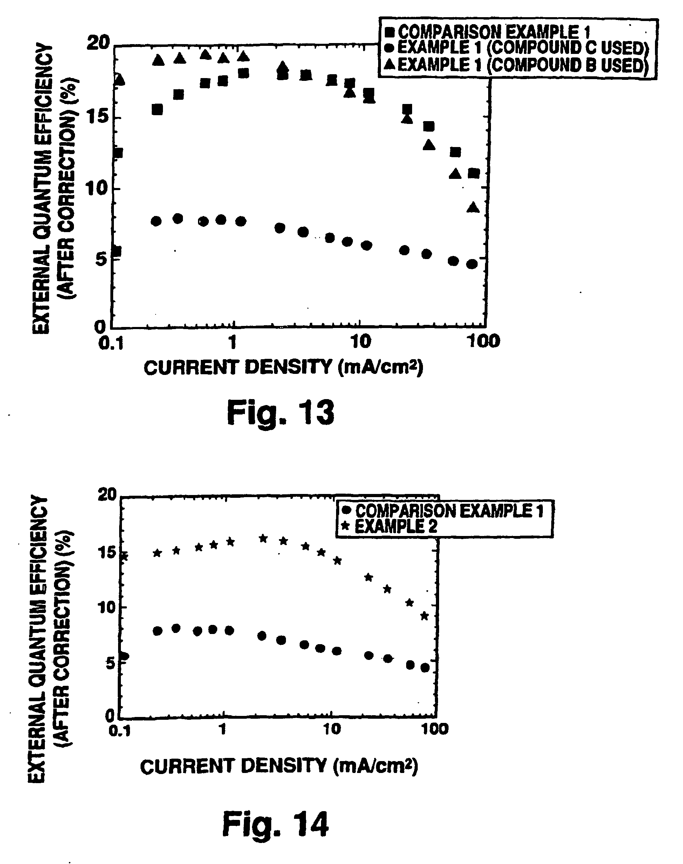

The ratio of the current density to the external quantum efficiency of the organic light-emitting devices of example 1 and comparison example 1 are shown in Fig . 13. The ratio of the current density to the external quantum efficiency of the organic light-emitting devices of example 2 and comparison example 1 are shown in Fig. 14. In each instance, it is evident that the external quantum efficiency of the devices of examples 1 and 2 of the present invention are drastically improved compared with that of the device of comparison example.

### Example 3

The organic light-emitting device formed in the above-described example 2 was placed in a isothermal oven. The temperature inside the oven was elevated from room temperature in 10°C intervals. After maintaining each temperature for one hour, the emission efficiency was measured. As a result, more than 50 % of the emission efficiency at room temperature was maintained, even at 100 °C.

### Comparison Example 2

The organic light-emitting device shown in comparison example 1 was placed in a isothermal oven and the emission efficiency was measured in such amanner as described inthe above-described example 3. As a result, even at a temperature of 80 °C, the emission ef ficiency was already lowered to approximately 20% of that at room temperature.

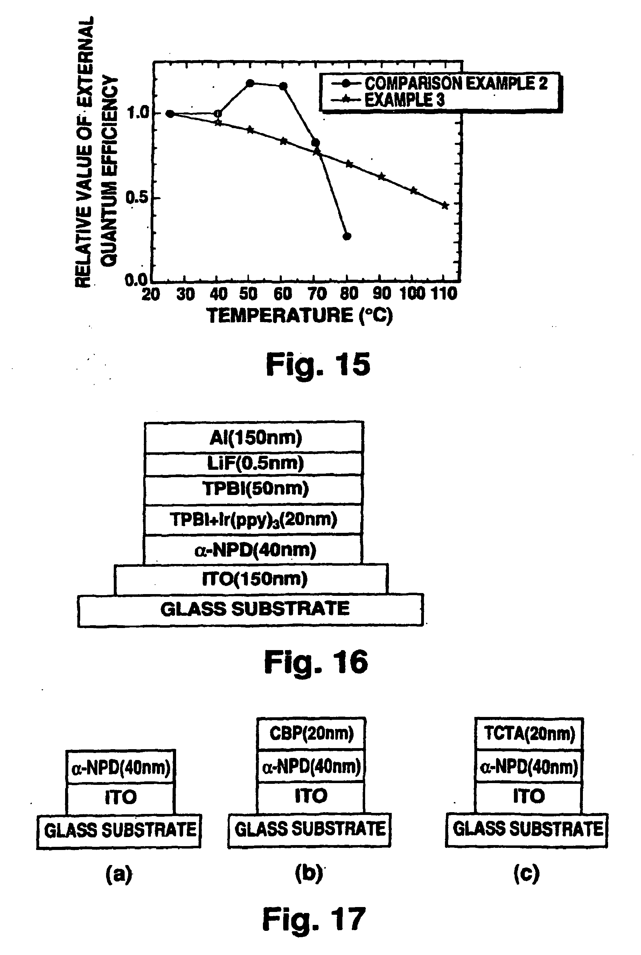

The results obtained by example 3 and comparison example 2 are shown in Fig. 15.

### Example 4

While TPBI, a compound of the imidazole family, was used as the hole blocking layer in example 2 as described above, a compound of the triazole family may be used instead because the compound of imidazole or triazole family is deep in its HOMO level and shallow in its LUMO level. Therefore, the hole and exciton can be efficiently blocked when it is used as the electron transporting layer.

### Example 5

On a glass substrate was formed a transparent electrode of ITO of 150 nm on which was deposited a α-NPD layer of 40 nm by means of vacuum evaporation at the vacuum level of 3×10⁻⁷ Torr to form a hole transporting layer. Further, a layer of TCBI as a host material doped with 7.5 wt % of Ir(ppy)₃ as dopant was formed to a thickness of 20 nm on the hole transporting layer to thereby form a light emitting layer. Then, on the light emitting layer was deposited a 50 nm TPBI layer. Finally, LiF and Al were deposited thereon in thickness of 0.5 nm and 150 nm, respectively, to form a metal electrode. Across-sectional view of the device thus formed is shown in Fig. 16. The device was placed in a chamber which was evacuated to a high vacuum. After thoroughly purging the inside of the chamber with nitrogen, an end of a seal glass was bonded by epoxy resin to the surface of the transparent electrode to seal. The organic light-emitting device of this example shown in Fig. 16 corresponds to the organic light-emitting device of embodiment 2 shown in Fig. 6.

A direct voltage was applied to the organic light-emitting device formed in such a manner as described above to drive continuously and the emission efficiency was measured. As a result, the external quantum efficiency after correction of angular distribution was 7%. While it was at the same level as that of the above-described comparison example 1, the organic light-emitting device formed in this example had improved heat-resistance and could maintain high emission efficiency at temperatures of 100 °C and above.

### Example 6

On a glass substrate was deposited an organic thin film having a combination shown in Figs. 17(a), 17(b) and 17(c), separately. Heat-resistance was compared for each organic thin film obtained. The thin film shown in Fig. 17(a) was formed by depositing ITO on a glass substrate and then depositing α-NPD on the ITO with thickness of 40 nm. The thin film shown in Fig. 17(b) was formed by depositing ITO on a glass substrate, then depositing α-NPD on the ITO with thickness of 40 nm, and finally depositing, commercially available CBP, on the α-NPD with thickness of 20 nm, similarly to Fig. 17(a). The thin film shown in Fig. 17(c) was formed by depositing ITO on a glass substrate, then depositing α-NPD on the ITO with thickness of 40 nm, and finally depositing TCTA on the α-NPD with thickness of 20 nm.

Morphology of the surface of each organic thin film formed in such a manner as described above was observed by atomic force microscopy (tapping mode)in a state where the temperature of each organic thin film was maintained at room temperature (25 °C). Thereafter, each organic thin film was placed in an oven, maintained at a temperature of 54 °C or 74 °C for one hour and cooled to room temperature. Then, morphology of the surfaces was observed by atomic force microscopy.

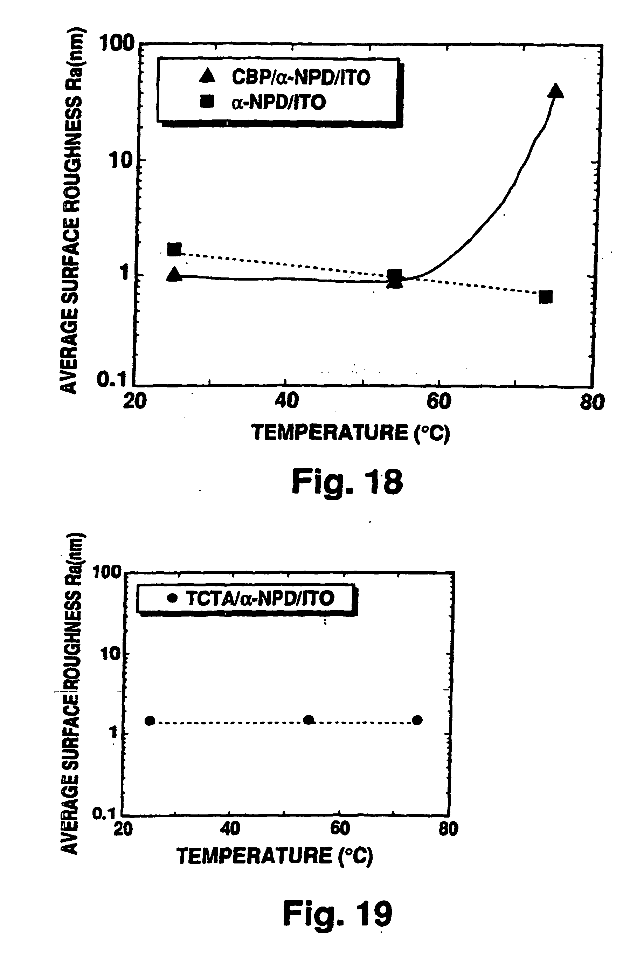

In the case of Fig. 17(a) in which only α-NPD was deposited on ITO, the average surface roughness minimized diminished as the temperature of the organic thin film increased. In the case of Fig. 17(b) in which CBP was deposited on the α-NPD, the surface morphology changed drastically and the surface roughness enlarged in the order of more than singlet figures at temperatures of 60 °C and above when the temperature of the organic thin film was increased. A state that the organic thin film aggregated was clearly observed. These results are shown in Fig. 18. In Fig. 18, an abscissa axis indicates the temperature of the organic thin film and an ordinate axis indicates the average surface roughness of the organic thin film. The results of Fig. 17(a) and Fig. 17(b) are shown by black squares and black triangles, respectively. It is evident, in particular, that the average surface roughness changes drastically at temperatures of 60 °C and above in the case of Fig. 17(b).

On the other hand, in the case shown in Fig. 17(c) in which TCTA was deposited on the α-NPD, although the average surface roughness did not entirely change when the temperature of the organic thin film was increased up to 75 °C, the surface morphology was maintained in its initial state. The result is shown in Fig. 19.

### Example 7

On a glass substrate was formed a transparent electrode of ITO with a thickness of 150 nm on which was deposited a α-NPD layer to a thickness of 40 nm by means of vacuum evaporation at a vacuum level of 5×10⁻⁷ Torr (6.65 ×10⁻⁵ Pa) to form a hole transporting layer. On the hole transporting layer was formed a layer having a thickness of 20 nm comprising 2, 2-bis (4-(4'-(N-carbazolyl) biphenyl) adamantan (AdBPCz having two phenyl groups, the aforementioned compound (a 3)) as the host material doped with 7 wt% of Ir(ppy)₃ as dopant, to thereby obtain a light emitting layer. On the light emitting layer was deposited a TPBI layer as a hole blocking layer with a thickness of 20 nm. Then Alq₃ as an electron transporting layer with a thickness of 30 nm was deposited. Thereon were deposited LiF with a thickness of 0.5 nm and Al with a thickness of 150 nm to form a metal electrode.

The device formed in the manner described above was placed in a high vacuumed chamber. After thoroughly purging the inside of the chamber with nitrogen of 1 atm, an end of a seal glass was bonded to the surface of the transparent electrode to seal with ultraviolet curing resin.

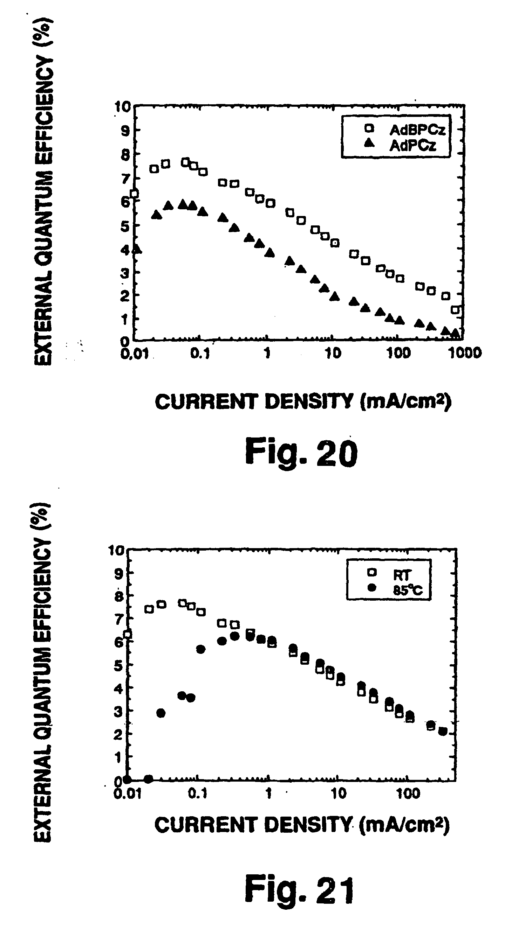

Fig. 20 shows a relationship between the current density and the external quantum efficiency in the case where (2, 2-bis (4-(N-carbazolyl) phenyl) adamantane, AdPCz) having one phenyl group and (2, 2-bis (4-(4'-(N-carbazolyl) biphenyl) adamantane, AdBPCz) having two phenyl groups which were belonged to the afore-mentioned compound (a 3) were used as the host material, respectively. As shown in Fig. 20, when AdBPCz was used and measurements were made, the external quantum efficiency reached a maximum of 8%. The external quantum efficiency of the organic light emitting device which was made by using AdPCz as the host material and the other materials as is the case with AdBPCz reached a maximum of 6%.

Fig. 21 shows results of measurements in an atmosphere at a room temperature and 85 °C for the organic light emitting device which was made by the use of the above-described AdBPCz. As shown in Fig. 21, the external quantum efficiency of the device measured after the device was left for three hours in an atmosphere at 85 C and measurement was made in such an atmosphere was little different from that measured at a room temperature, because the host material used has heat-resistance. Taking into consideration the fact that the external quantum efficiency lowered drastically at 85 °C when CBP was used for the host material, it is evident that 2, 2-bis(4-(4'-(N-carbazolyl)biphenyl)adamantane is excellent in heat-resistance.

The above-described 2, 2-bis (4-(N-carbazolyl) phenyl) adamantane was synthesized through the procedure described below.

1.0 g(1.85 millimol) of 2,2-(4-Iodophenyl)adamantane, 3.10 g(18. 5 millimol)of carbazole, 2.6 g(18.8 millimol)of K₂CO₃, 2.3 g (36.2 millimol) of copper powder, 0.8g(5.58 millimol)of CuBr and 15g of decahydronaphthalene(Decalin, trade name) were mixed and stirred at 180 t in an atmosphere of nitrogen for 20 hours. After cooling the reaction solution was added 50 ml of CHCl₃ and filtered. The filtrate obtained was concentrated and residue was purified by the use of silica gel column (CHCl₃ : hexane =1:2). Solid obtained was recrystallized from CHCl₃ to obtain 176.5 mg of 2, 2-bis (4-(N-carbazolyl) phenyl) adamantane as light yellow powder.

The structure of this material was identified by an infrared spectrophotometer (IR) and a nuclear magnetic resonance (NMR). Data for IR and NMR were shown below.
IR (KBR): 3040, 2900, 2850, 1620, 1600, 1510, 1450, 1330, 1310, 1225, 745, 720 cm
NMR (CDCl₃): 8.13(d, 4H), 7.71(d, 4H), 7.51(d, 4H), 7.46(d, 4H), 7.40(t, 4H), 7.27(t, 4H), 3.42(s, 2H), 2. 20(d, 4H), 1.88(dd, 8H)

The structural formula of this 2, 2-bis (4-(N-carbazolyl) phenyl) adamantane was as illustrated below;

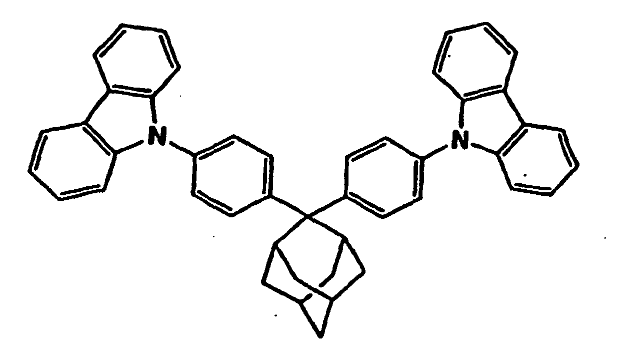

The above-described 2,2-bis(4-(4'-(N-carbazolyl)biphenyl) adamantane were synthesized by procedures (1) and (2) described below.

### (1) Synthesis of 4-(N-carbazolyl) phenyl borate

2.0 g(5.42 millimol)of N-(4-Iodophenyl)carbazole were added into mixed solution of 5 ml of THF and 5 ml of diethyl ether and cooled to -90 °C in an atmosphere of nitrogen. Into the solution were added dropwise 3.8 ml (5.7 millimol) of 1.5M n-BuLi solution (n-hexane). Then, stirring was accomplished at temperatures of -90 °C and below and were added slowly dropwise 0.01 ml(5.44 millimol)of trimethoxy borate. After stirring at a temperature of no more than -90 °C for 20 minutes, stirring was performed for one hour at room temperature. Thereafter, 3 ml of water and 20 ml of 2N aqueous solution of NaOH were added to separate the aqueous phase. Then, the organic phase was extracted twice with 20 ml of 2N aqueous solution of NaOH and the aqueous phases obtained were combined. The aqueous phases were neutralized with 1N aqueous solution of H₂SO₄ and the precipitate was filtered and rinsed. The precipitate was dissolved in 75 ml of CHCl₃ and the solution was concentrated after drying with Na₂SO₄. The precipitate was recrystallized from 50 ml of toluene to obtain 1.07 g of 4-(N-carbazolyl) phenyl borate as white powder.

The structure of this material was identified by an infrared spectrophotometer (IR) and a nuclear magnetic resonance (NMR). Data for IR and NMR were shown below.
IR (KBR): 3380, 3280, 3060, 1605, 1450, 1410, 1375, 1345, 1330, 1305, 1220, 1170, 745, 720, 690 cm⁻¹
NMR (CDCl₃): 8.33(s, 2H), 8.31(d, 2H), 8.15(d, 2H), 7.66(d, 2H), 7.50(t, 2H), 7.48(d, 2H), 7.36(t, 2H)

The structural formula of this 4-(N-carbazolyl)phenyl borate was as illustrated below;

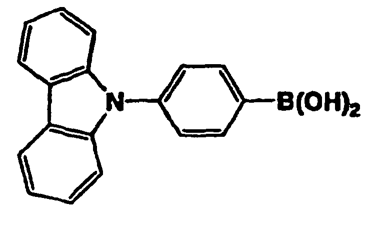

### (2) Synthesis of 2,2-bis(4-(4'-(N-carbazolyl)biphenyl)adamantan

1.0 g(3.48 millimol)of 4-(N-carbazolyl)phenyl borate, 627 mg(1.16 millimol)of2,2-bis(4-Iodophenyl)adamantane,26 mg(0.116 millimol) of Pd(OAc)₂, 106 mg(0.348 millimol)of tri(o-toluyl)phosphine, 558 mg(5.26 millimol) of Na₂CO₃, 11 ml of 1,2-dimethoxyethane and 2 ml of water were mixed and stirred at 100 °C in an atmosphere of nitrogen for 15 hours. After cooling, to the reaction solution was added 15 ml of water and extracted with CHCl₃. The CHCl₃ phase was washed with saturated salt solution and dried with Na₂SO₄ and, then the solution was concentrated. The residue was purified by the use of silica gel column (CHCl₃ : hexane =1:2 to 1:3) to obtain 234.4 mg of 2, 2-bis (4-(4'-(N-carbazolyl) bisphenyl) adamantane as light yellow powder.

The structure of this material was identified by an infrared spectrophotometer (IR) and a nuclear magnetic resonance (NMR). Data for IR and NMR were shown below.
IR (KBR): 3050, 2905, 2860, 1620, 1600, 1520, 1500, 1480, 1455, 1370, 1335, 1315, 1230, 810, 750, 720 cm⁻¹
NMR (CDCl₃): 8.15(d, 4H), 7.77(d, 4H), 7.61(s, 8H), 7.59(d, 4H), 7.47-7.40(m, 8H), 7.29(t, 4H), 3.39(s, 2H), 2.16(d, 4H), 1.91-1.79(m, 8H)

The structural formula of this 2, 2-bis (4-(4'-(N-carbazolyl) bisphenyl) adamantan was as illustrated below;

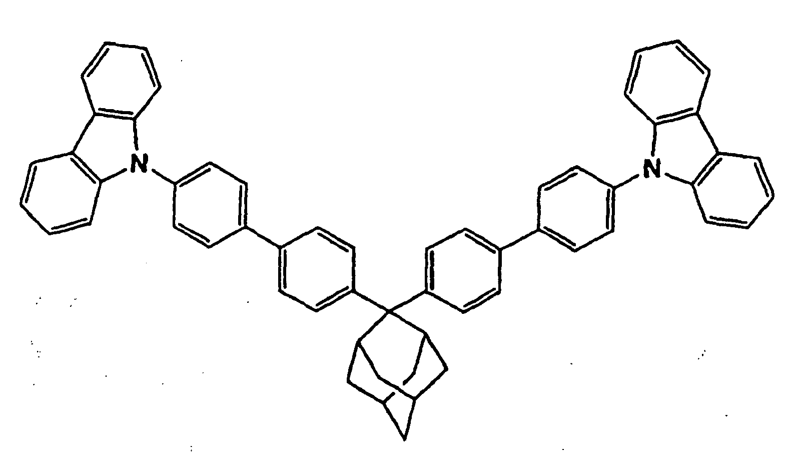

### Example 8

On a glass substrate was formed a transparent electrode of ITO with thickness of 150 nm on which was deposited a α-NPD layer of 40 nm by means of vacuum evaporation at the vacuum level of 5×10⁻⁷ Torr to form a hole transporting layer. On the hole transporting layer was formed a layer having thickness of 20 nm comprising 1, 3, 5-tris-[4-(N-carbazolyl)phenyl]benzene (TCPB, the afore-mentioned compound (a4)) having a glass transition temperature (Tg)of 172 °C as the host material doped with 7 wt% of Ir(ppy)₃ as dopant to obtain a light emitting layer. On the light emitting layer thus obtained was deposited a TPBI layer as a hole blocking layer with a thickness of 20 nm, and then was deposited Alq₃ as an electron transporting layer with a thickness of 30 nm. Thereon were deposited LiF with a thickness of 0.5 nm and Al with a thickness of 150 nm to form a metal electrode.

The device formed as described above was placed in a vacuum chamber which was evacuated to 1×10⁻⁶ Torr. After thoroughly purging the inside of the chamber with nitrogen of 1 atm, an end of a seal glass was bonded by ultraviolet curing resin to the surface of the transparent electrode to seal.

A direct voltage was applied to the organic light-emitting device to drive continuously and the emission efficiency was measured. As a result, the maximum external quantum efficiency was 12%. When the initial luminance was 1,500 cd/m², the half life in luminance of this device was 300 hours. This result was longer than that obtained by using CBP as a host material. Further, when the initial luminance was 1,500 cd/m², the half life in luminance of this device was 250 hours in an atmosphere of 85 °C. Compared with the fact that the half life in luminance in an atmosphere of 85 °C in the case of using CBP was less than half of that at room temperature, it was evident that the device of example 8 was high in durability at high temperatures.

In an organic light-emitting device, either a hole transporting layer or an electron transporting layer comprises a light emitting layer doped with phosphorescent molecule and a host material constituting the hole transporting layer or electron transporting layer has the properties emitting phosphorescence having spectra which overlap with spectra of the phosphorescent molecule and a glass transition temperature of 100 °C and above. Therefore, the device exhibits superior phosphorescence emission efficiency and heat-resistance.

## Claims

1. An organic light-emitting device emitting phosphorescence comprising a plurality of organic layers, wherein said organic layers comprise a hole transporting layer and an electron transporting layer, and a phosphorescent molecule is doped into a host material of either said hole transporting layer or said electron transporting layer to be applied for a light emitting layer,
wherein a host material constituting said hole transporting layer includes a compound having the structural formulae illustrated below: 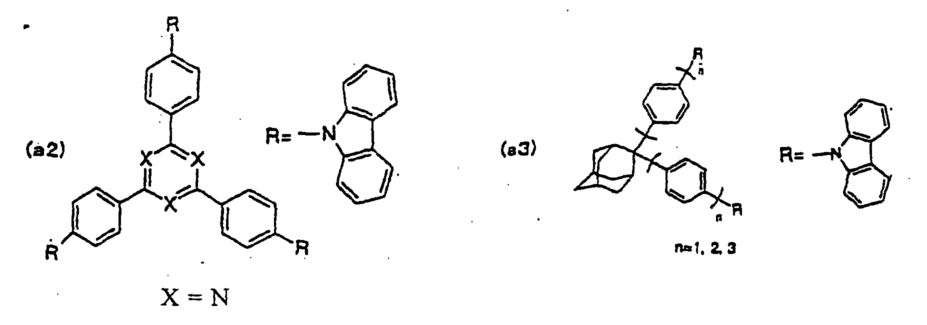 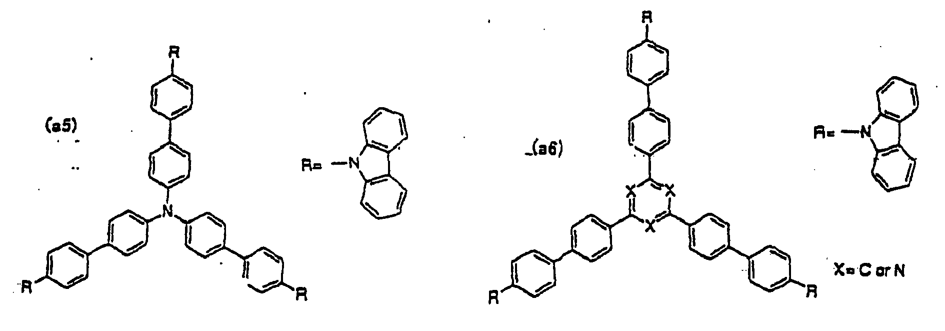 wherein R is H, or hydrocarbons, or fluorocarbons,
wherein a host material constituting said electron transporting layer is one selected from the group consisting of a triazole compound, an imidazole compound,
and an oxadiazole compound,
wherein said triazole compound includes compounds having the structural formulae: 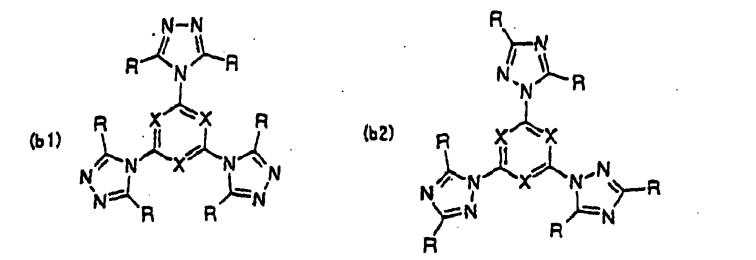 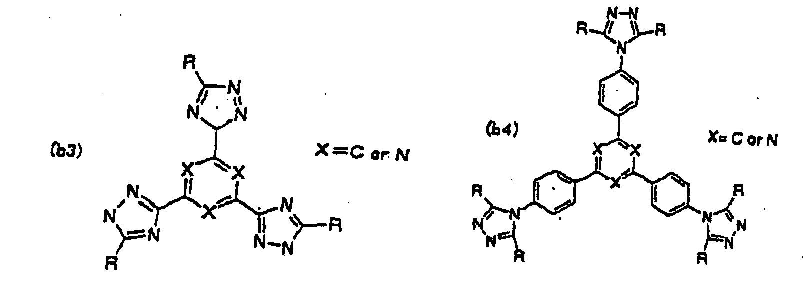 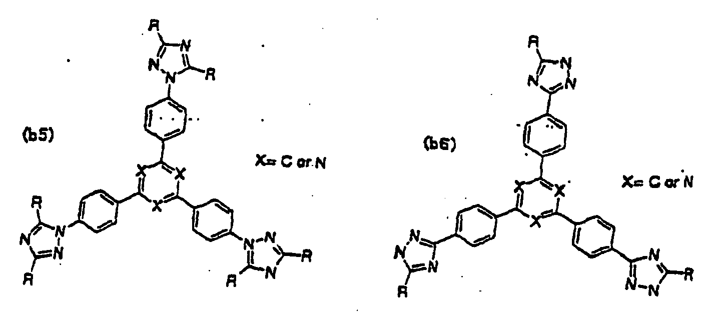 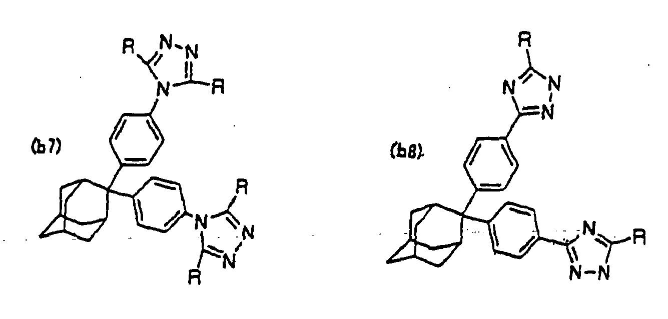 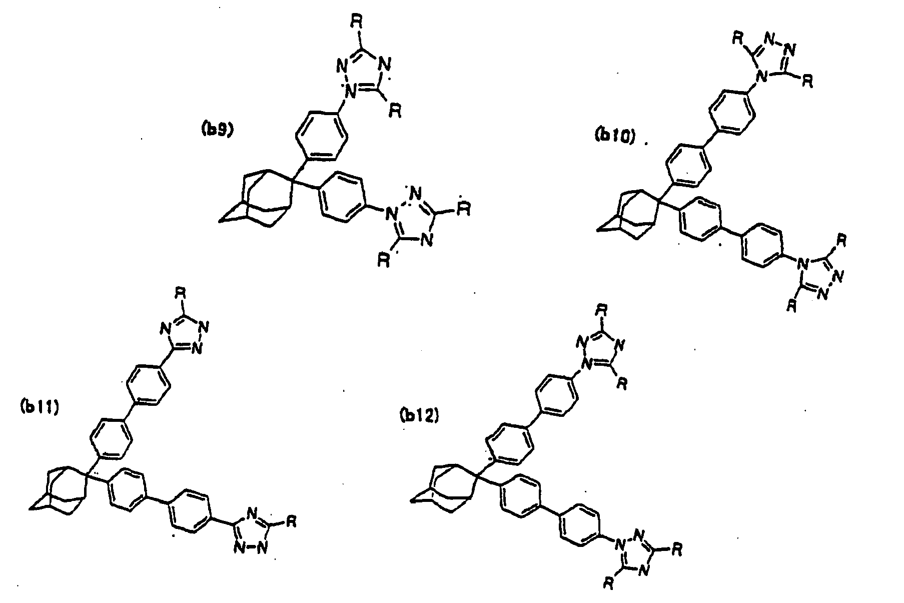 where 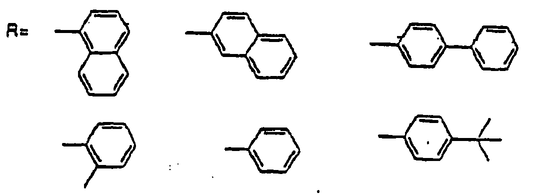 -H alkyl group having carbon atom of five or less
, wherein R is H, or hydrocarbons, or fluorocarbons,
wherein said imidazole compound includes compounds having the structural formulae: 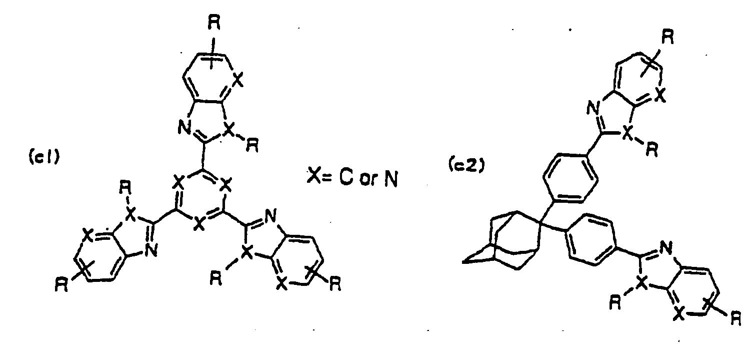 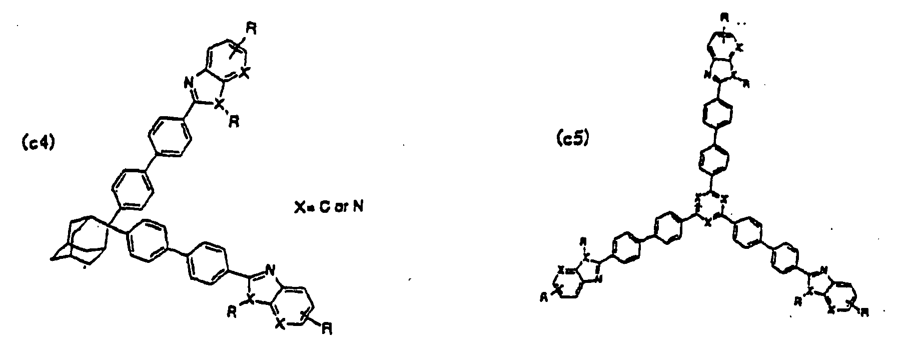 where 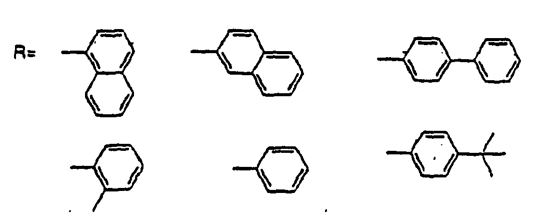 -H alkyl group having carbon atom. of five or less
, wherein R is H, or hydrocarbons, or fluorocarbons,
and
wherein said oxadiazole compound includes compounds having the structural formulae: 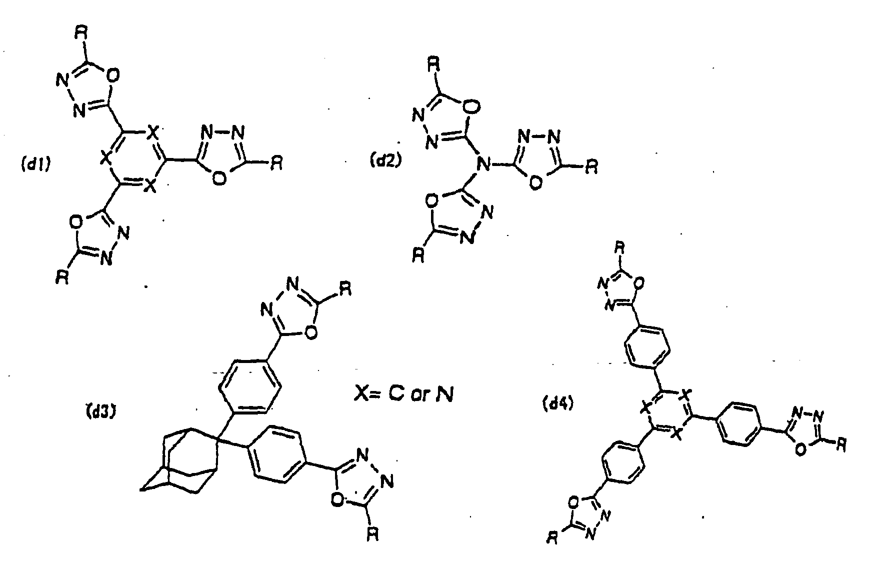 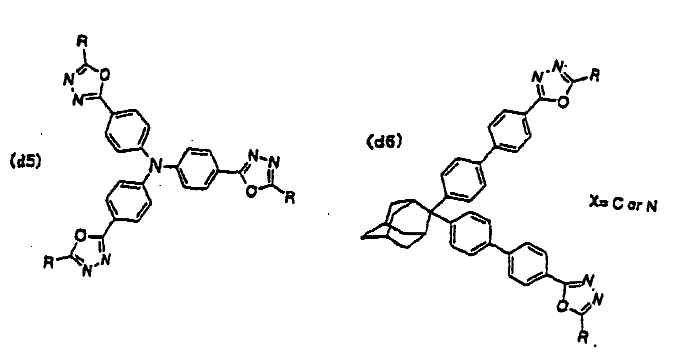 where 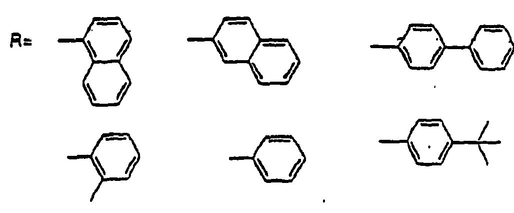 -H alkyl group having carbon atom of five or less
, wherein R is H, or hydrocarbons, or fluorocarbons,
and has a glass transition temperature of 100 °C or above.

2. The organic light-emitting device as described in claim 1, wherein an organic compound having two or more of aromatic tertiary amine units is used for said hole transporting layer, an organic compound having two or more of imidazole units is used for said electron transporting layer, and the phosphorescent molecule is doped into said host material of said hole transporting layer to be applied for the light emitting layer.

3. The organic light-emitting device as described in claim 2, wherein said phosphorescent molecule is not doped into said host material of an area on the side of an anode of said hole transporting layer.

4. The organic light-emitting device as described in claim 3, wherein the thickness of the area not doped with said phosphorescent molecule in said hole transporting layer is at least 10 nm from an anode and a thickness of the layer doped with said phosphorescent molecule in said hole transporting layer is not more than 50 nm from an interface between said hole transporting layer and said electron transporting layer.

5. The organic light-emitting device as described in claim 1, wherein an organic compound having two or more of aromatic tertiary amine units is used for said hole transporting layer and an organic compound having two or more of imidazole units is used for said electron transporting layer, and said phosphorescent molecule is doped into said host material of said electron transporting layer to be applied for the light emitting layer.

6. The organic light-emitting device as described in any one of claims 1 to 5, wherein there is a region where an emission spectrum of said host material overlaps an absorption spectrum of said phosphorescent molecule, which is a guest material.

7. The organic light-emitting device as described in any one of claims 1 to 5, wherein said host material itself emits phosphorescence and there is a region where a phosphorescence spectrum of said host material overlaps a phosphorescence spectrum of said phosphorescent molecule as a guest material.

8. The organic light-emitting device as described in any one of claims 1 to 5, wherein there is a region where a fluorescence spectrum of said host material overlaps an absorption spectrum of said phosphorescent molecule.

9. The organic light-emitting device as described in any one of claims 1 to 8, wherein between said light emitting layer and a metal electrode is inserted a layer of an electron transporting compound having a band-gap larger than that of said light emitting layer and an ionization potential at least 0.1 eV greater than that of said light emitting layer.

10. The organic light-emitting device as described in claim 9, wherein said layer of an electron transporting compound comprises an organic electron transporting fluorobenzene compound.

## Patentansprüche

1. Organische lichtemittierende Vorrichtung, die Phosphoreszenz emittiert und eine Mehrzahl von organischen Schichten umfasst, wobei die organischen Schichten eine Löchertransportschicht und eine Elektronentransportschicht umfassen und ein phosphoreszierendes Molekül in ein Wirtsmaterial entweder der Löchertransportschicht oder der Elektronentransportschicht, die für eine lichtemittierende Schicht eingesetzt wird, dotiert ist,
wobei ein Wirtsmaterial, das die Löchertransportschicht bildet, eine Verbindung mit den nachstehend gezeigten Strukturformeln umfasst: 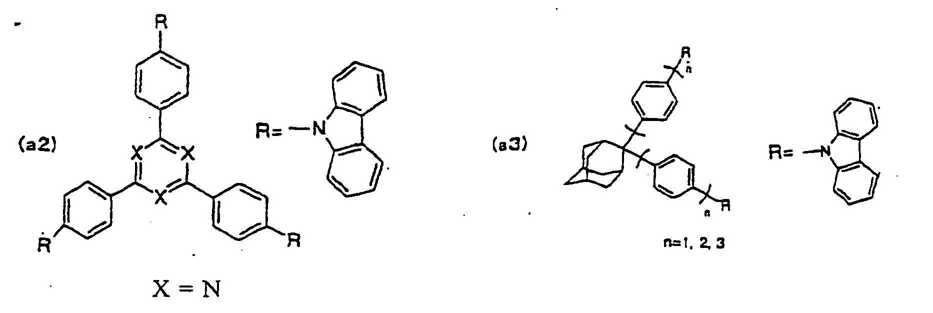 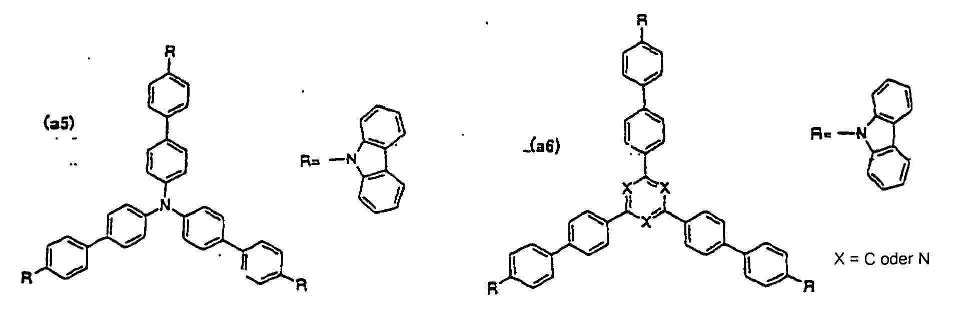 worin R H oder Kohlenwasserstoffe oder Fluorkohlenstoffe ist,
wobei ein Wirtsmaterial, das die Elektronentransportschicht bildet, ein Material ist, das aus der Gruppe, bestehend aus einer Triazolverbindung, einer Imidazolverbindung und einer Oxadiazolverbindung, ausgewählt ist,
wobei die Triazolverbindung Verbindungen umfasst, welche die Strukturformeln aufweisen: 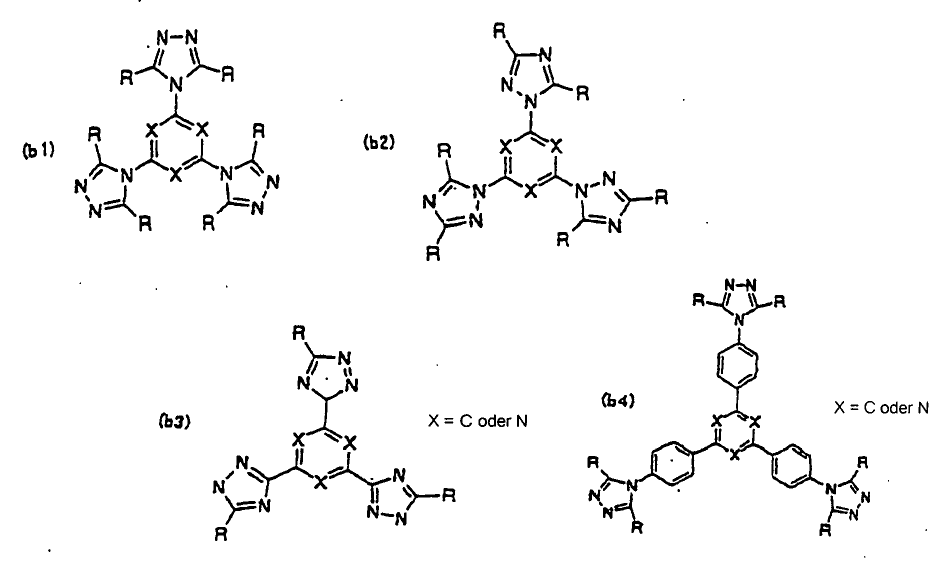 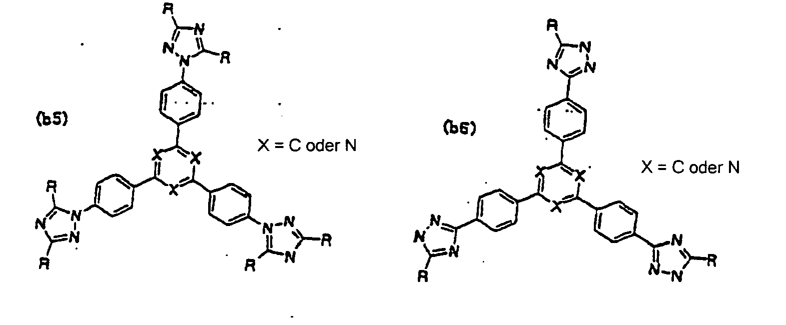 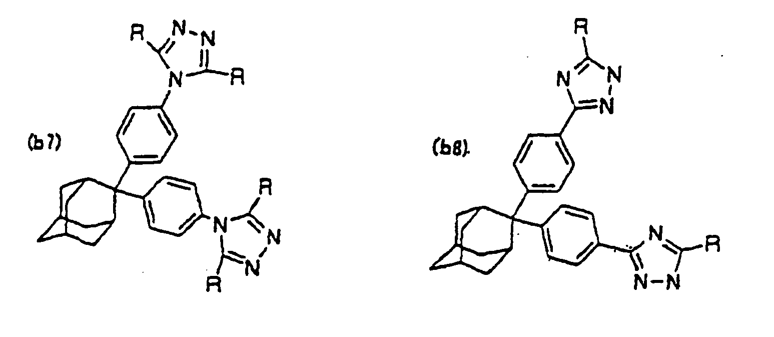 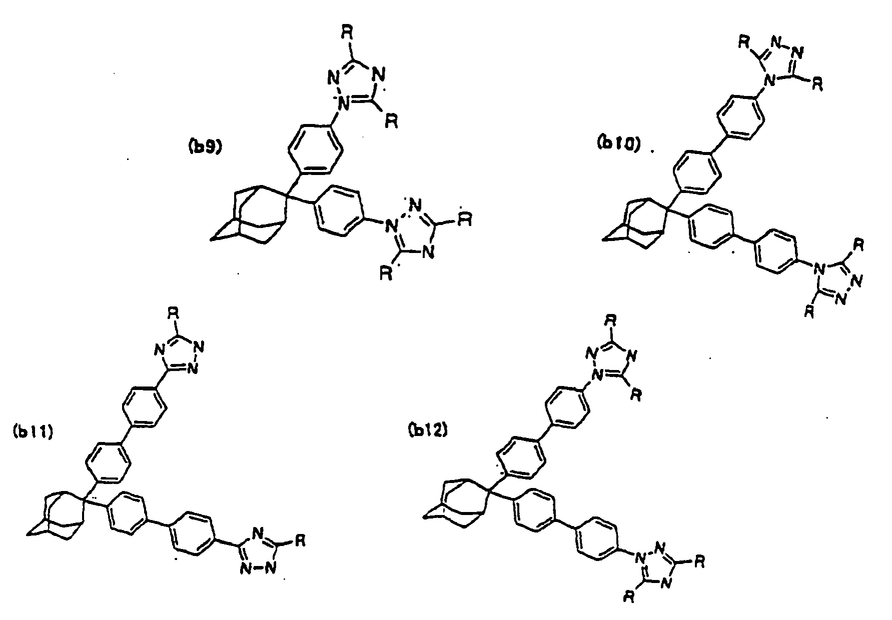 worin 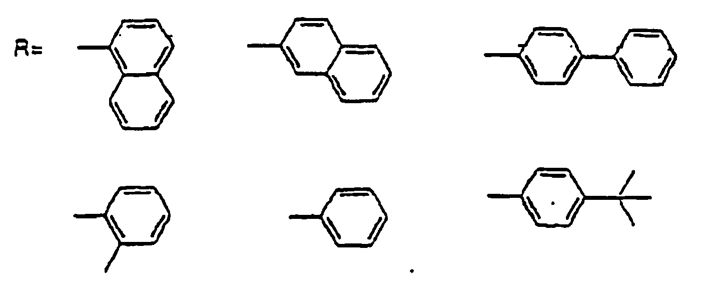 -H, eine Alkylgruppe mit 5 Kohlenstoffatomen oder weniger,
worin R H oder Kohlenwasserstoffe oder Fluorkohlenstoffe ist,
wobei die Imidazolverbindung Verbindungen umfasst, welche die Strukturformeln aufweisen: 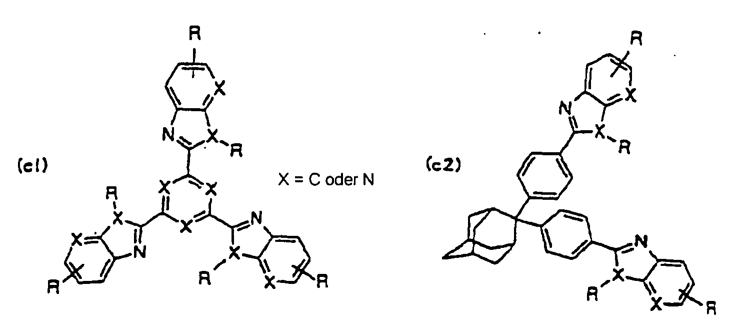 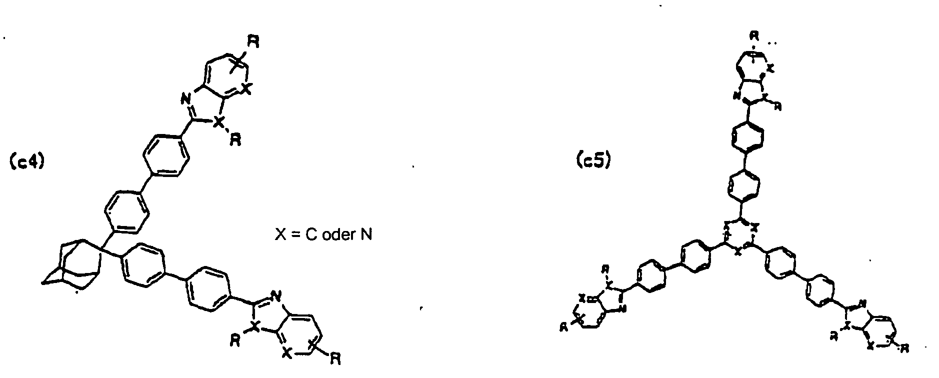 worin 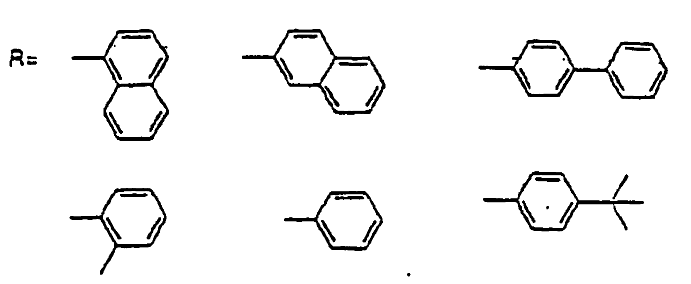 -H, eine Alkylgruppe mit 5 Kohlenstoffatomen oder weniger,
worin R H oder Kohlenwasserstoffe oder Fluorkohlenstoffe ist,
wobei die Oxadiazolverbindung Verbindungen umfasst, welche die Strukturformeln aufweisen: 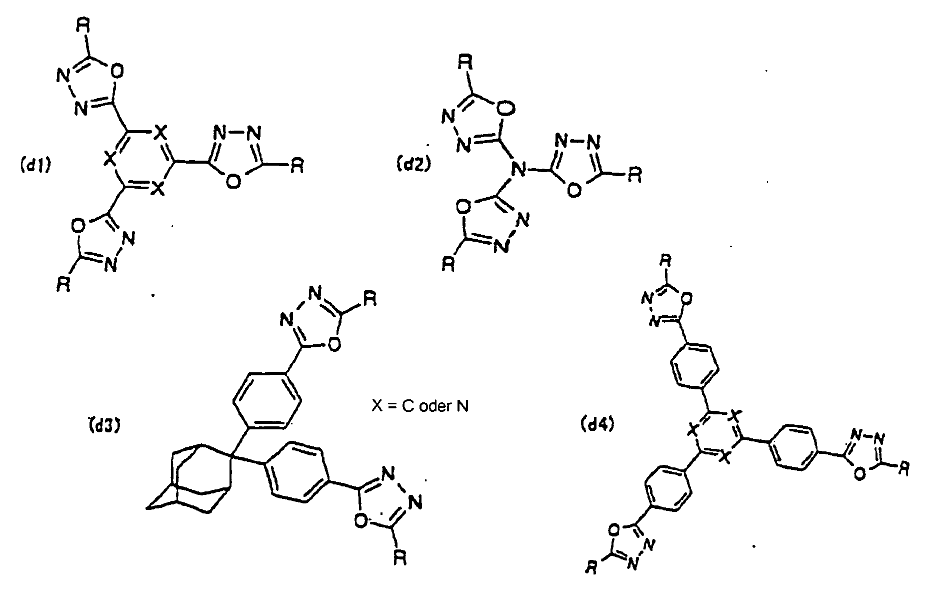 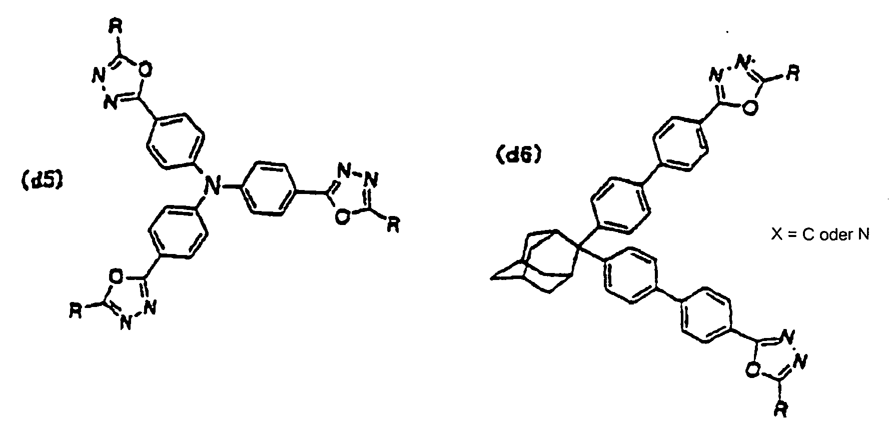 worin 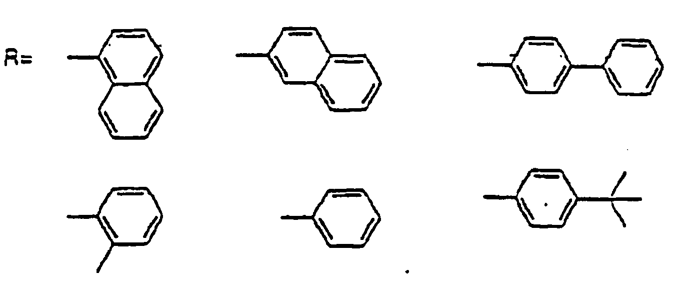 -H, eine Alkylgruppe mit 5 Kohlenstoffatomen oder weniger,
worin R H oder Kohlenwasserstoffe oder Fluorkohlenstoffe ist,
und eine Glasübergangstemperatur von 100 °C oder mehr aufweist.

2. Organische lichtemittierende Vorrichtung nach Anspruch 1, bei der eine organische Verbindung mit zwei oder mehr aromatischen tertiären Amineinheiten für die Löchertransportschicht verwendet wird, eine organische Verbindung mit zwei oder mehr Imidazoleinheiten für die Elektronentransportschicht verwendet wird und das phosphoreszierende Molekül in das Wirtsmaterial der Löchertransportschicht dotiert ist, die für die lichtemittierende Schicht eingesetzt wird.

3. Organische lichtemittierende Vorrichtung nach Anspruch 2, bei der das phosphoreszierende Molekül nicht in das Wirtsmaterial eines Bereichs auf der Seite einer Anode der Löchtertransportschicht dotiert ist.

4. Organische lichtemittierende Vorrichtung nach Anspruch 3, bei der die Dicke des Bereichs, der nicht mit dem phosphoreszierenden Molekül in der Löchertransportschicht dotiert ist, ausgehend von einer Anode mindestens 10 nm beträgt, und bei der die Dicke der Schicht, die mit dem phosphoreszierenden Molekül in der Löchertransportschicht dotiert ist, ausgehend von einer Grenzfläche zwischen der Löchertransportschicht und der Elektronentransportschicht nicht mehr als 50 nm beträgt.

5. Organische lichtemittierende Vorrichtung nach Anspruch 1, bei der eine organische Verbindung mit zwei oder mehr aromatischen tertiären Amineinheiten für die Löchertransportschicht und eine organische Verbindung mit zwei oder mehr Imidazoleinheiten für die Elektronentransportschicht verwendet wird und das phosphoreszierende Molekül in das Wirtsmaterial der Elektronentransportschicht dotiert ist, die für die lichtemittierende Schicht eingesetzt wird.

6. Organische lichtemittierende Vorrichtung nach einem der Ansprüche 1 bis 5, bei der ein Bereich vorliegt, bei dem das Emissionsspektrum des Wirtsmaterials mit dem Absorptionsspektrum des phosphoreszierenden Moleküls, das ein Gastmaterial ist, überlappt.

7. Organische lichtemittierende Vorrichtung nach einem der Ansprüche 1 bis 5, bei der das Wirtsmaterial selbst eine Phosphoreszenz emittiert und ein Bereich vorliegt, bei dem das Phosphoreszenzspektrum des Wirtsmaterials mit dem Phosphoreszenzspektrum des phosphoreszierenden Moleküls, das ein Gastmaterial ist, überlappt.

8. Organische lichtemittierende Vorrichtung nach einem der Ansprüche 1 bis 5, bei der ein Bereich vorliegt, bei dem das Fluoreszenzspektrum des Wirtsmaterials das Absorptionsspektrum des phosphoreszierenden Moleküls überlappt.

9. Organische lichtemittierende Vorrichtung nach einem der Ansprüche 1 bis 8, bei der zwischen der lichtemittierenden Schicht und einer Metallelektrode eine Schicht aus einer Elektronentransportverbindung eingeschoben ist, die eine Bandlücke, die größer ist als die Bandlücke der lichtemittierenden Schicht, und ein Ionisierungspotenzial aufweist, das mindestens um 0,1 eV größer ist als das Ionisierungspotenzial der lichtemittierenden Schicht.

10. Organische lichtemittierende Vorrichtung nach Anspruch 9, bei der die Schicht aus der Elektronentransportverbindung eine organische Fluorbenzol-Elektronentransportverbindung umfasst.

## Revendications

1. Dispositif organique électroluminescent émettant de la phosphorescence comprenant une pluralité de couches organiques, dans lequel lesdites couches organiques comprennent une couche de transport de trous et une couche de transport d'électrons, et une molécule phosphorescente est dopée dans un matériau hôte soit de ladite couche de transport de trous, soit de ladite couche de transport d'électrons à appliquer pour une couche d'émission de lumière,
dans lequel un matériau hôte constituant ladite couche de transport de trous comprend un composé ayant les formules de structure illustrées ci-dessous : 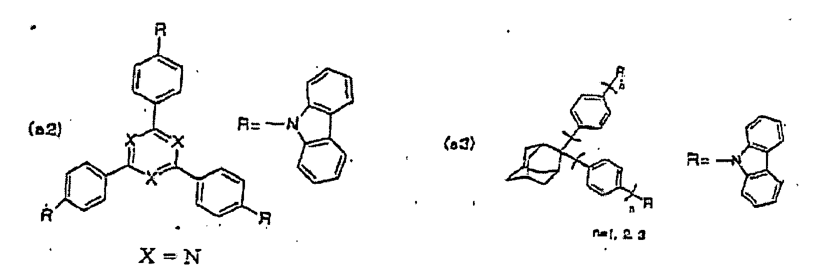 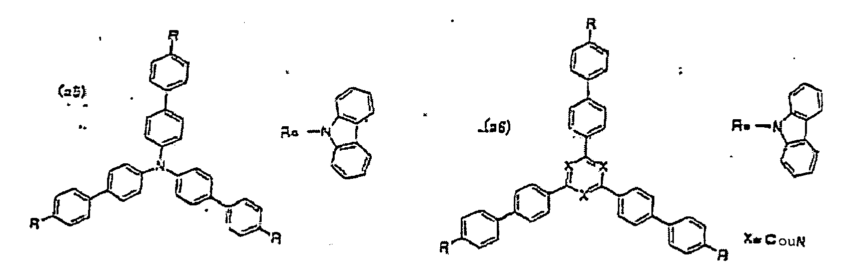 dans lesquelles formules R est H ou des hydrocarbures ou des fluorocarbures,
dans lequel un matériau hôte constituant ladite couche de transport d'électrons est un matériau sélectionné dans le groupe constitué d'un composé de triazole, d'un composé d'imidazole et d'un composé d'oxadiazole,
dans lequel ledit composé de triazole englobe les composés ayant les formules de structure suivantes : 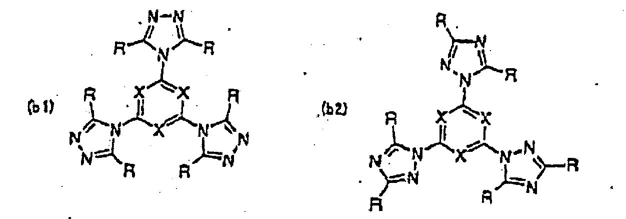 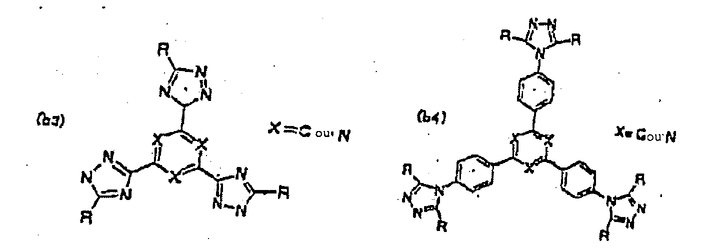 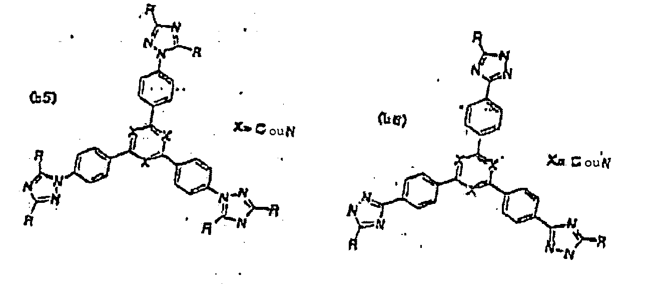 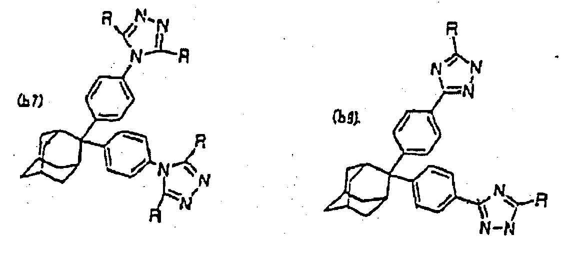 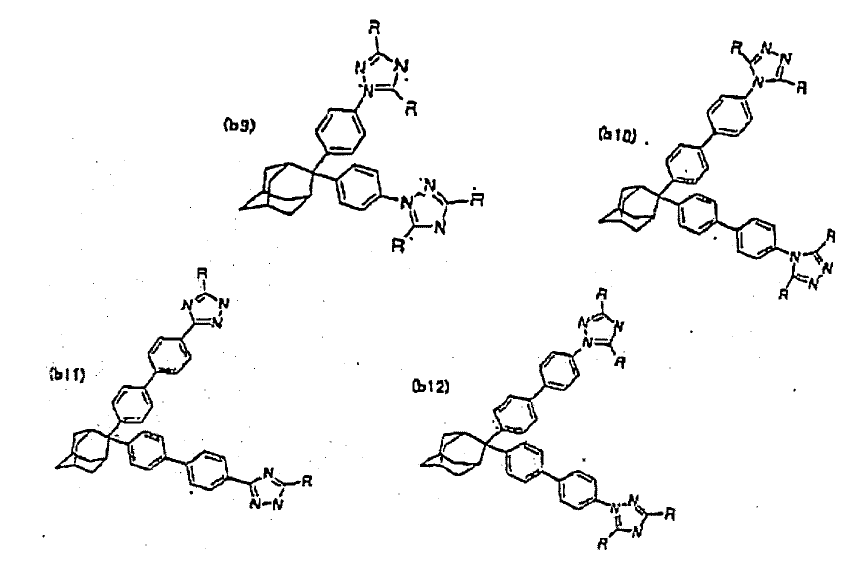 où 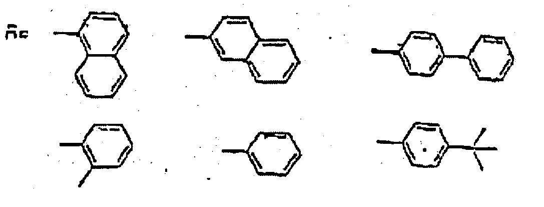 -H, un groupement alkyle ayant cinq atomes de carbone ou moins,
dans lesquelles R représente H, des hydrocarbures ou des fluorocarbures,
dans lequel ledit composé d'imidazole englobe des composés ayant les formules de structure : 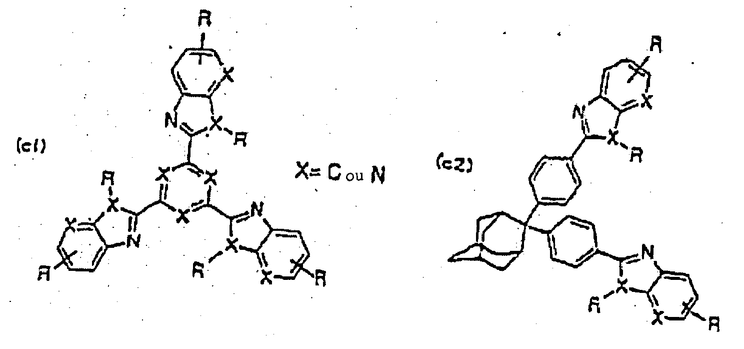 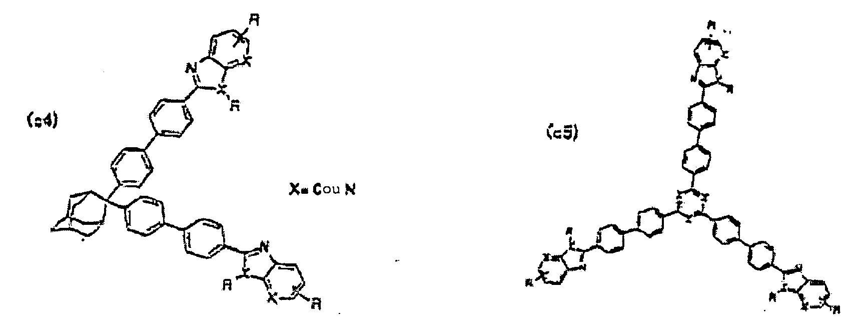 où 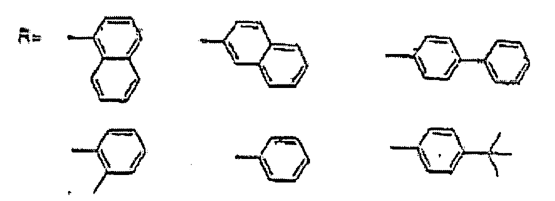 -H, un groupement alkyle ayant cinq atomes de carbone ou moins,
dans lesquelles R est H ou des hydrocarbures ou des fluorocarbures,
et
dans lesquelles ledit composé d'oxadiazole englobe des composés ayant les formules de structure : 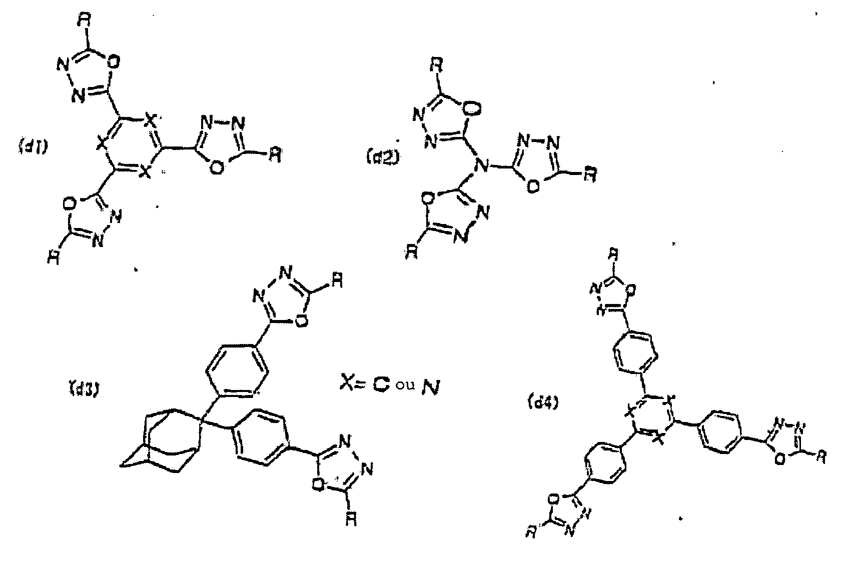 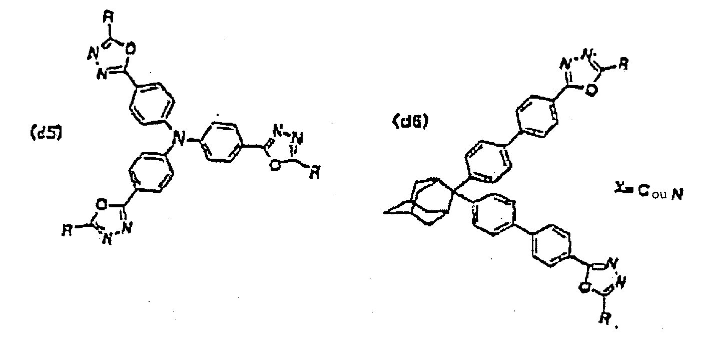 où 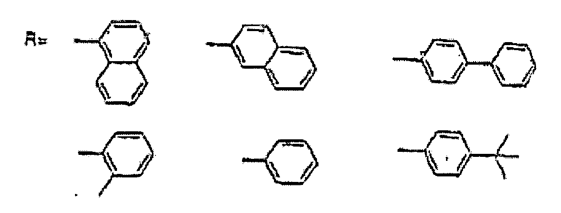 -H, un groupement alkyle ayant cinq atomes de carbone ou moins,
dans lesquelles R est H ou des hydrocarbures ou des fluorocarbures, et a une température de transition vitreuse de 100 °C ou plus.

2. Dispositif organique électroluminescent suivant la revendication 1, dans lequel un composé organique ayant deux unités de type amine tertiaire aromatique ou plus est utilisé pour ladite couche de transport de trous, un composé organique ayant deux unités imidazole ou plus est utilisé pour ladite couche de transport d'électrons et la molécule phosphorescente est dopée dans ledit matériau hôte de ladite couche de transport de trous à appliquer pour la couche d'émission de lumière.

3. Dispositif organique électroluminescent suivant la revendication 2, dans lequel ladite molécule phosphorescente n'est pas dopée dans ledit matériau hôte sur une zone du côté d'une anode de ladite couche de transport de trous.

4. Dispositif organique électroluminescent suivant la revendication 3, dans lequel l'épaisseur de la région non dopée avec ladite molécule phosphorescente dans ladite couche de transport de trous est au moins de 10 nm d'une anode et une épaisseur de la couche dopée par ladite molécule phosphorescente dans ladite couche de transport de trous n'est pas plus de 50 nm d'une interface entre ladite couche de transport de trous et ladite couche de transport d'électrons.

5. Dispositif organique électroluminescent suivant la revendication 1, dans lequel un composé organique ayant deux unités de type amine tertiaire ou plus est utilisé pour ladite couche de transport de trous et un composé organique ayant deux unités imidazole ou plus est utilisé pour ladite couche de transport d'électrons et ladite molécule phosphorescente est dopée dans ledit matériau hôte de ladite couche de transport d'électrons pour être appliquée pour la couche d'émission de lumière.

6. Dispositif organique électroluminescent suivant l'une quelconque des revendications 1 à 5, dans lequel il y a une région dans laquelle un spectre d'émission dudit matériau hôte chevauche un spectre d'absorption de ladite molécule phosphorescente qui est un matériau reçu.

7. Dispositif organique électroluminescent suivant l'une quelconque des revendications 1 à 5, dans lequel ledit matériau hôte lui-même émet une phosphorescence et il y a une région où le spectre de phosphorescence dudit matériau hôte chevauche un spectre de phosphorescence de ladite molécule phosphorescente servant de matériau reçu.

8. Dispositif organique électroluminescent suivant l'une quelconque des revendications 1 à 5, dans lequel il y a une région dans laquelle un spectre de fluorescence dudit matériau hôte chevauche un spectre d'absorption de ladite molécule phosphorescente.

9. Dispositif organique électroluminescent suivant l'une quelconque des revendications 1 à 8, dans lequel il est inséré, entre la couche d'émission de lumière et une électrode métallique, une couche d'un composé de transport d'électrons ayant une bande interdite plus grande que celle de ladite couche d'émission de lumière et un potentiel d'ionisation plus grand d'au moins 0,1 eV que celui de ladite couche d'émission de lumière.

10. Dispositif organique électroluminescent suivant la revendication 9, dans lequel ladite couche d'un composé de transport d'électrons comprend un composé de fluorobenzène organique de transport d'électrons.
